(19) **Europäisches Patentamt / European Patent Office / Office européen des brevets**

(11) **EP 3 799 671 B1**

(12) **FASCICULE DE BREVET EUROPEEN**

(45) Date de publication et mention de la délivrance du brevet:
**08.06.2022 Bulletin 2022/23**

(21) Numéro de dépôt: **19731772.0**

(22) Date de dépôt: **24.06.2019**

(51) Classification Internationale des Brevets (IPC):
**G01R 19/14** *(2006.01)* **G01R 19/25** *(2006.01)*
**G01R 31/08** *(2020.01)* **H02H 7/26** *(2006.01)*
**H02J 1/14** *(2006.01)* **H02J 3/36** *(2006.01)*
**H02H 7/28** *(2006.01)*

(52) Classification Coopérative des Brevets (CPC):
**H02H 7/28; G01R 31/081; H02H 7/268; H02J 1/14; H02J 3/36;** G01R 19/14; G01R 19/2513; G01R 31/52; Y02E 60/60

(86) Numéro de dépôt international:
**PCT/EP2019/066718**

(87) Numéro de publication internationale:
**WO 2020/002266 (02.01.2020 Gazette 2020/01)**

(54) **SYSTÈME COMPRENANT UN DISPOSITIF DE CONTRÔLE DE FLUX DE PUISSANCE UTILISÉ POUR CONTRÔLER LA RÉPARTITION DES COURANTS DANS UN RÉSEAU MAILLÉ ET DES MOYENS DE PROTECTION DUDIT DISPOSITIF**

SYSTEM MIT EINER LEISTUNGSFLUSSSTEUERVORRICHTUNG ZUR STEUERUNG DER VERTEILUNG VON STRÖMEN IN EINEM STROMNETZ UND MITTEL ZUM SCHUTZ DIESER VORRICHTUNG

SYSTEM COMPRISING A POWER FLOW CONTROL DEVICE USED TO CONTROL THE DISTRIBUTION OF CURRENTS IN A GRID NETWORK AND MEANS FOR PROTECTING SAID DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.06.2018 FR 1855652**

(43) Date de publication de la demande:
**07.04.2021 Bulletin 2021/14**

(73) Titulaire: **Supergrid Institute**
**69100 Villeurbanne (FR)**

(72) Inventeurs:
- **POULLAIN, Serge**
 **69007 LYON (FR)**
- **MOREL, Florent**
 **69007 LYON (FR)**
- **TOURE, Séllé**
 **69007 LYON (FR)**

(74) Mandataire: **Opilex**
**32, rue Victor Lagrange**
**69007 Lyon (FR)**

(56) Documents cités:
**EP-A1- 3 032 677    WO-A1-2013/013858**
**FR-A5- 2 084 971**

## Description

## Domaine technique de l'invention

La présente invention se rapporte à un système qui comporte un dispositif de contrôle de flux de puissance utilisé pour contrôler la répartition des courants dans un réseau maillé et des moyens de protection adaptés permettant de protéger ledit dispositif en cas de défaut électrique.

## Etat de la technique

Un réseau est un ensemble de lignes aériennes ou de câbles appelés par la suite « liaisons » qui connectent entre elles des dispositifs (ou terminaux) afin qu'ils échangent de l'énergie. Dans un réseau à courant continu, les dispositifs qui fournissent ou consomment de l'énergie sont généralement des convertisseurs électroniques de puissance nommés "stations de conversion".

Si le réseau est maillé, le courant dispose de plusieurs chemins possibles pour aller d'une station de conversion à une autre. Les courants dans les liaisons se répartissent en fonction des caractéristiques des liaisons (en continu, cette caractéristique est la résistance de la liaison).

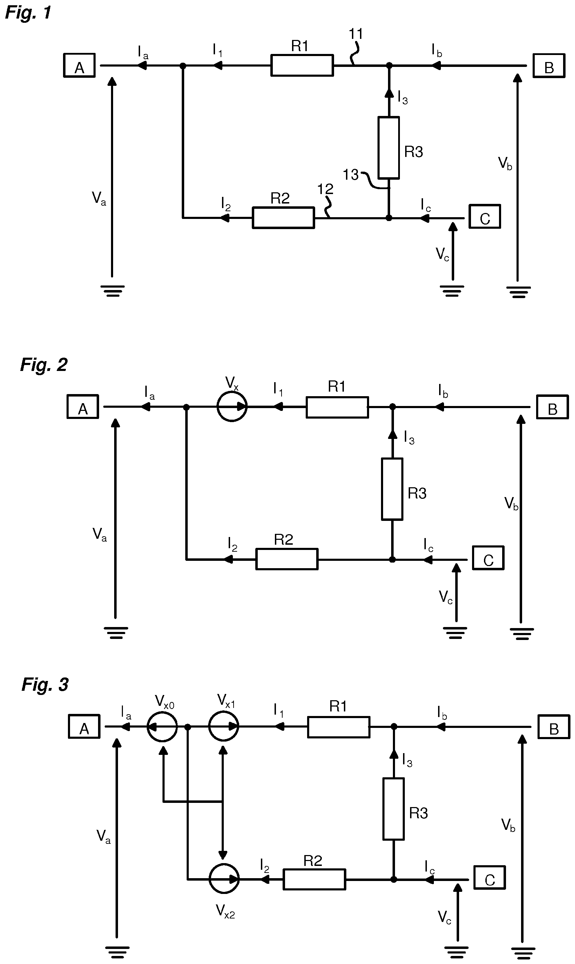

La figure 1 représente un réseau maillé doté d'une seule maille. Ce réseau comporte ainsi trois nœuds qui sont chacun à une tension déterminée et trois liaisons, dites première liaison reliant le premier nœud au deuxième nœud, deuxième liaison reliant le premier nœud au troisième nœud et troisième liaison reliant le deuxième nœud au troisième nœud.

Par exemple, sur le réseau représenté sur la figure 1, les trois tensions $V_a$, $V_b$, $V_c$ représentent les tensions imposées par des stations de conversions. Les trois résistances R1, R2, R3 représentent les résistances des liaisons.

Chaque station de conversion est apte à injecter ou extraire une puissance du réseau. Dans cette configuration, les courants ($I_1$, $I_2$, $I_3$) dans chaque liaison ne sont pas contrôlés par les stations de conversion. En effet, chaque station de conversion impose au réseau, au nœud où elle est connectée, une tension déterminée. Alors que le courant dans chaque station de conversion est inférieur à son courant maximal, il est possible d'atteindre des points de fonctionnement pour lesquels une liaison est traversée par un courant supérieur à son courant maximal alors que d'autres liaisons dans le réseau (qui pourraient être utilisées pour transférer l'énergie) sont en sous-charge.

Dans une architecture telle que représentée sur la figure 1, dans le cas où les stations de conversion B et C fournissent de l'énergie au réseau et la station de conversion A reçoit de l'énergie, le courant dispose de deux chemins possibles pour aller de la station B à la station A :

- Il peut passer directement par la première liaison 11 ou,
- Il peut passer par les deux liaisons 13 et 12.

La répartition entre les deux chemins sera notamment déterminée en fonction des valeurs des résistances des liaisons et des tensions imposées par les stations de conversion du réseau.

Pour assurer une meilleure répartition du courant dans les liaisons d'un réseau maillé, il a été proposé dans l'état de la technique d'insérer dans la maille un dispositif de contrôle de flux de puissance (appelé également PFC pour "Power Flow Controller").

Certains de ces dispositifs utilisent une seule source de tension mise en série avec une liaison, comme schématisé sur la figure 2. Le réglage de cette tension permet de modifier la répartition des courants dans le réseau. Des architectures de ce type ont été décrites dans les demandes de brevet WO2010/115452A1, WO2013/013858A1.

Des dispositifs de contrôle de flux de puissance qui ajoutent une source de tension en série avec deux liaisons en alternance ont également été décrits dans les demandes EP3007301A1 et EP3007300A1.

Un autre dispositif de contrôle de flux de puissance décrit dans la demande de brevet WO2013/178807A1 (ou son correspondant US2015/180231A1) et schématisé sur la figure 3 consiste à insérer deux sources de tension ($V_{x1}$, $V_{x2}$) en série chacune avec une liaison distincte et une source de tension ($V_{x0}$) en série avec une station de conversion. Sur cette figure 3, les double-flèches symbolisent la capacité d'échange d'énergie entre les sources.

La demande de brevet EP3032677A1 décrit également un système employé dans un réseau maillé, comprenant un dispositif de contrôle de flux de puissance.

Dans de tels dispositifs de contrôle de flux de puissance, différents types de défauts électriques peuvent survenir. Les défauts peuvent être dits internes et concerner la défaillance d'un ou plusieurs des composants du dispositif lui-même (inductance, condensateur, interrupteur, défaut pôle-terre au niveau de la carcasse du dispositif...) et dits externes, c'est-à-dire issus du réseau DC lui-même, comme par exemple un défaut de type pôle-terre ou de type pôle-pôle.

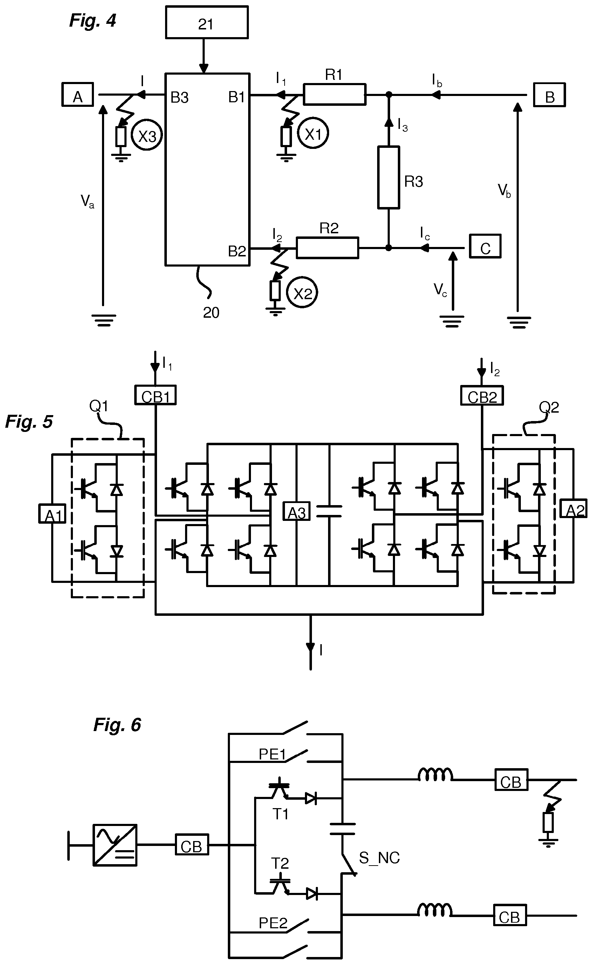

La figure 4 illustre la présence des différents types de défauts pôle-terre, référencés X1, X2, X3, pouvant survenir dans un réseau maillé doté d'un dispositif de contrôle de flux de puissance tel qu'évoqué ci-dessus (représenté de manière schématique sur la figure 4).

Les différentes demandes de brevet antérieures citées ci-dessus ne proposent aucune solution de protection des dispositifs de contrôle de flux de puissance contre ces défauts externes (dont certains peuvent coïncider avec certains défauts internes).

Pour l'heure, les travaux sur la protection de ces dispositifs sont relativement peu nombreux. On peut néanmoins citer deux publications proposant des systèmes et stratégies de protection.

La solution proposée dans la première publication référencée "S. Balasubramaniam "Experimental Validation of Dual H-Bridge Current Flow Controllers for Meshed HVDC Grids", IEEE Transactions on Power Delivery, Issue : 99, 18 September2017"est montrée sur la figure 5.

L'idée générale de la solution proposée dans cette publication est la suivante : ajouter des interrupteurs (Q1, Q2) pour "by-passer"/contourner tout le dispositif de contrôle de flux de puissance en cas de défaut, en attendant l'ouverture des disjoncteurs DC (CB1, CB2) pour couper le courant et utiliser des dispositifs de limitation en tension (A1, A2, A3).

Mais cette solution est tributaire du système de protection global, notamment de la présence des disjoncteurs DC qui se doivent d'être très rapides. En effet, le temps de réponse ou de coupure des disjoncteurs détermine le dimensionnement en courant des interrupteurs Q1 et Q2, qui ont pour fonction de court-circuiter entièrement le dispositif de type PFC en cas de défaut. Ces interrupteurs Q1 et Q2 doivent être également réversibles en tension comme en courant. Grace à la présence des parafoudres aux bornes de la capacité et des interrupteurs, cette solution offre une protection en tension.

En présence de disjoncteurs DC lents, les interrupteurs Q1 et Q2 devront présenter un dimensionnement en courant très important. Or les interrupteurs employés (IGBT) dans cette solution ne permettent pas de fortes surcharges en courant.

La solution proposée dans la deuxième publication référencée "J. Sau-Bassols"Series interline DC/DC Current Flow Controller for meshed HVDC grids", IEEE Transactions on Power Delivery, Issue : 99, 31 July 2017" est représentée sur la figure 6. Cette solution, comme la précédente, est basée sur un système de protection utilisant les éléments de protection du réseau comme les disjoncteurs ("CB" sur la figure). En plus de ces éléments, elle utilise des interrupteurs PE1 et PE2 de "by-pass"/contournement qui doivent être réversibles en tension comme en courant pour fonctionner et des inductances de limitation. L'interrupteur de type normalement fermé (S_NC) a normalement pour fonction d'isoler la capacité et de la protéger contre les surtensions. Mais pour isoler la capacité, il doit alors disposer d'un pouvoir de coupure. Cette solution ne peut ainsi fonctionner qu'en employant un interrupteur S_NC avec un grand pouvoir de coupure, car il s'agit d'interrompre le courant des inductances. De plus cet interrupteur, placé en série avec le condensateur, va faire apparaitre une inductance parasite dans la maille de commutation (lorsque le courant commute de l'interrupteur T1 à l'interrupteur T2) ce qui tend à augmenter les surtensions aux bornes des interrupteurs T1 et T2 ainsi que les pertes par commutation.

Il en ressort que ces deux solutions connues de protection présentent notamment les inconvénients suivants :

- Elles nécessitent l'emploi d'interrupteurs de "by-pass"/contournement qui sont réversibles en courant et en tension ;
- Elles dépendent des solutions de protection globales du réseau, notamment les disjoncteurs, ou utilisent directement ces solutions ;
- Elles peuvent nécessiter l'emploi de disjoncteurs à action rapide, notamment si l'on cherche à réduire le dimensionnement des interrupteurs du dispositif de type PFC ;
- Elles nécessitent l'emploi de dispositifs de coupure pour isoler les sources de tension ;

Le but de l'invention est de proposer un système qui comporte un dispositif de contrôle de flux de puissance utilisable dans un réseau maillé tel que décrit ci-dessus pour répartir les courants et des moyens de protection adaptés dudit dispositif, lui permettant de faire face aux défauts de type externe identifiés ci-dessus. Les moyens de protection employés seront notamment adaptés pour fonctionner sur différentes topologies de dispositif de contrôle de flux de puissance.

**Exposé de l'invention**

Ce but est atteint par un système destiné à être employé dans un réseau maillé, une maille comportant au moins trois nœuds chacun à une tension déterminée, ledit système comportant un dispositif de contrôle de flux de puissance agencé pour contrôler le flux de puissance dans la maille et qui comporte une première borne destinée à être connectée à une première liaison de la maille, une deuxième borne destinée à être connectée à une deuxième liaison de la maille et une troisième borne destinée à être connectée à une liaison du réseau, au moins une source de tension passive, des moyens de commutation connectés à ladite source de tension passive et des moyens de commande configurés pour commander lesdits moyens de commutation pour assurer une répartition des courants dans lesdites deux liaisons de la maille, ledit dispositif comprenant plusieurs diodes et lesdits moyens de commutation comprenant plusieurs commutateurs choisis parmi :

- Un interrupteur contrôlé non réversible ;
- Un interrupteur contrôlé réversible en courant ;
- Un interrupteur contrôlé réversible en tension ;
- Un interrupteur contrôlé réversible en courant et en tension ;
- Un commutateur mécanique ;
- Un commutateur mécanique connecté en série avec une diode ;
- Un commutateur mécanique connecté en série avec un interrupteur contrôlé ;

Le système comprenant des moyens de détection d'un défaut électrique au sein du dispositif et des moyens d'identification du type de défaut électrique détecté,

Ledit système comportant des moyens de protection dudit dispositif de contrôle de flux de puissance, lesdits moyens de protection comprenant :

- Un interrupteur de contournement placé en parallèle de chaque diode du dispositif de contrôle de flux de puissance ;
- Un interrupteur de contournement placé en parallèle de chaque commutateur du dispositif de contrôle de flux de puissance, hormis si le commutateur est un interrupteur contrôlé non réversible ;
- Un dispositif de limitation de tension connecté aux bornes de chaque source de tension passive ;
  Et en ce qu'il comporte des moyens de commande de chaque interrupteur de contournement et de chaque moyen de commutation du dispositif de contrôle de flux de puissance selon une séquence de commande adaptée au type de défaut électrique identifié.

Selon une réalisation particulière, chaque interrupteur de contournement comporte un thyristor, deux thyristors connectés en tête bêche ou un groupement de thyristors connectés en parallèle et/ou en série.

Selon une autre réalisation particulière, chaque dispositif de limitation de tension comporte au moins un parafoudre.

Selon une autre réalisation particulière, le système comporte au moins un dispositif de limitation de tension connecté entre au moins deux bornes du dispositif de contrôle de flux de puissance.

Selon une autre réalisation particulière, le système comporte trois bornes, une première borne reliée à ladite première borne du dispositif de contrôle de flux de puissance, une deuxième borne reliée à ladite deuxième borne du dispositif de contrôle de flux de puissance, une troisième borne reliée à ladite troisième borne du dispositif de contrôle de flux de puissance et il comporte au moins un dispositif de limitation de variation de courant connecté entre l'une de ses trois bornes et la borne correspondante du dispositif de contrôle de flux de puissance.

Selon une réalisation particulière, le système comporte au moins un dispositif de limitation de tension connecté entre deux de ses trois bornes.

Selon une autre réalisation particulière, le dispositif de contrôle de flux de puissance comporte :

- Une première source de tension connectée entre sa première borne et sa troisième borne,
- Une deuxième source de tension connectée entre sa deuxième borne et sa troisième borne,
- Une source de courant connectée alternativement à la première source de tension et à la deuxième source de tension et configurée pour assurer un transfert d'énergie entre la première source de tension et la deuxième source de tension,
- Lesdits moyens de commutation étant configurés pour permettre une connexion de ladite source de courant en alternance, en parallèle de la première source de tension ou en parallèle de la deuxième source de courant,
- Lesdits moyens de commande étant configurés pour commander lesdits moyens de commutation de manière à réaliser ladite connexion de ladite source de courant en alternance, en parallèle de la première source de tension ou en parallèle de la deuxième source de courant et commander un transfert d'énergie entre la première source de tension et la deuxième source de tension via ladite source de courant.

Selon une autre réalisation particulière, la première source de tension comporte au moins un condensateur.

Selon une autre réalisation particulière, la deuxième source de tension comporte au moins un condensateur.

Selon une autre réalisation particulière, la source de courant comporte au moins une inductance.

Selon une autre réalisation particulière, les moyens de commutation comportent six commutateurs :

- Un premier ensemble de deux premiers commutateurs connecté entre la première borne et la troisième borne du dispositif, en parallèle de la première source de tension, les deux commutateurs du premier ensemble définissant entre eux un premier point milieu de connexion ;

- Un deuxième ensemble de deux deuxièmes commutateurs connecté entre la deuxième borne et la troisième borne, en parallèle de la deuxième source de tension, les deux commutateurs du deuxième ensemble définissant entre eux un deuxième point milieu de connexion ;

- Un troisième commutateur connecté entre la deuxième borne et le premier point milieu du premier ensemble de commutateurs ;

- Un quatrième commutateur connecté entre la première borne et le deuxième point milieu du deuxième ensemble de commutateurs.

Selon une réalisation particulière, l'inductance est connectée entre le premier point milieu et le deuxième point milieu.

Selon une autre réalisation particulière, chaque commutateur est choisi en fonction du signe des paramètres suivants :

- Le courant $I_1$ ;

- Le courant $I_2$ ;

- Le ratio $I_1/I_2$ ;

- La différence $I_1$-$I_2$ ;

- La différence $V_x = V_1 - V_2$ ;

- Le ratio $\frac{V_1 - V_2}{I_1 + I_2}$ ;

Dans lesquelles :

- $I_1$ correspond au courant qui circule dans la première liaison ;

- $I_2$ correspond au courant qui circule dans la deuxième liaison ;

- V1 correspond à la tension aux bornes de la première source de tension ;

- V2 correspond à la tension aux bornes de la deuxième source de tension.

Selon une autre réalisation particulière, chaque commutateur est choisi parmi :

- Un circuit ouvert ;

- Un court-circuit ;

- Une diode ;

- Un interrupteur contrôlé non réversible ;

- Un interrupteur contrôlé réversible en courant ;

- Un interrupteur contrôlé réversible en tension ;

- Un interrupteur contrôlé réversible en courant et en tension ;

- Un commutateur mécanique seul ;

- Un commutateur mécanique en série avec une diode ;

- Un commutateur mécanique en série avec un interrupteur contrôlé ;

Selon une autre réalisation particulière, ledit dispositif de contrôle de flux de puissance comporte une source de tension et en ce que les moyens de commutation comportent des interrupteurs organisés en trois bras de commutation connectés chacun en parallèle de la source de tension, chaque bras de commutation comprenant deux interrupteurs en série, le point milieu du premier bras de commutation étant relié à la première borne du dispositif, le point milieu du deuxième bras de commutation étant relié à la deuxième borne et le point milieu du troisième bras de commutation étant relié à la troisième borne du dispositif.

La solution proposée permet notamment :

- De réduire les contraintes en tension comme en courant du dispositif de contrôle de flux de puissance.

- De réduire le nombre de composants et les coûts associés au dispositif de contrôle de flux de puissance.

- De dimensionner le dispositif de contrôle de flux de puissance pour des niveaux de tension relativement bas (Moyenne Tension, comme pour le régime normal).

- De diminuer l'encombrement, si possible.

- D'assurer une fiabilité sur la durée de vie du matériel.

**Brève description des figures**

D'autres caractéristiques et avantages vont apparaître dans la description détaillée qui suit, faite en regard des figures annexées listées ci-dessous :

- La figure 1 représente un réseau maillé minimal à une seule maille.

- Les figures 2 et 3 représentent de manière schématique des solutions connues dans l'état de la technique de dispositifs de contrôle de flux de puissance employés dans un réseau maillé.

- La figure 4 représente de manière schématique un dispositif de contrôle de flux de puissance de l'invention incorporé dans un réseau maillé et montre la localisation des défauts de type pôle-terre, pouvant être présents en amont et en aval du dispositif.

- Les figures 5 et 6 représentent des solutions de protection connues employées sur des dispositifs de contrôle de flux de puissance employés dans un réseau maillé.

- La figure 7A illustre par un tableau les moyens employés pour la protection d'un dispositif de contrôle de flux de puissance. Dans le tableau de cette figure 7A, la première ligne illustre les moyens de protection de manière générale et la deuxième ligne représente un exemple particulier de réalisation de ces moyens de protection.

- La figure 7B représente le schéma général de protection appliqué à un dispositif de contrôle de flux de puissance.

- Les figures 8A, 9A et 10A représentent plusieurs variantes de réalisation d'un dispositif de contrôle de flux de puissance, chacune incorporée dans un réseau maillé et les figures 8B, 9B et 10B représentent ces différentes variantes de réalisation auxquelles ont été ajoutées des moyens de protection conformément aux principes exposés sur les figures 7A et 7B.

- La figure 11 représente une variante de réalisation du dispositif de contrôle de flux de puissance et les figures 11.1_A, 11.2_A, 11.3_A et 11.4_A représentent plusieurs réalisations concrètes du dispositif de la figure 11.

- Les figures 11.1_B, 11.2_B, 11.3_B et 11.4_B représentent ces différentes réalisations auxquelles ont été ajoutés des moyens de protection conformément aux principes exposés sur les figures 7A et 7B.
- La figure 12A représente le diagramme général des étapes mises en œuvres lors du fonctionnement du système de l'invention ; La figure 12B illustre les principes de commande qui sont appliqués au système en fonction du défaut identifié ; La figure 12C représente un exemple d'algorithme employé pour la détection des défauts pour un système qui comporte un dispositif conforme à deux sources de tension tel que représenté sur la figure 11 ;
- Les figures 13A à 17B illustrent différentes séquences de commande en protection appliquées à certains des dispositifs représentés sur les figures précédentes.

**Description détaillée d'au moins un mode de réalisation**

Un dispositif de contrôle de flux de puissance de l'invention (également appelé PFC pour "Power Flow Controller") est destiné à être employé dans un réseau maillé, préférentiellement haute tension, à courant continu. Selon sa configuration, il pourra également être employé dans un réseau maillé à courant alternatif. Ce sera le cas lorsque les moyens de commutation comportent des interrupteurs de puissance réversibles en courant et en tension.

Comme déjà évoqué ci-dessus en liaison avec la figure 1, un réseau maillé se présente, de la manière la plus simple, sous la forme de trois nœuds interconnectés.

Chaque nœud est avantageusement connecté directement ou indirectement à une ou plusieurs stations de conversion. La station de conversion A est ainsi connectée au premier nœud. La station de conversion B est ainsi connectée au deuxième nœud du réseau. La station de conversion C est ainsi connectée au troisième nœud du réseau.

Chaque station de conversion est destinée à injecter une puissance sur le réseau ou extraire une puissance du réseau.

Chaque station de conversion est destinée à injecter un courant sur le réseau ou extraire un courant du réseau maillé. Il s'agit du courant $I_a$ pour la station de conversion A, du courant $I_b$ pour la station de conversion B et du courant $I_c$ pour la station de conversion C.

Une tension est imposée sur chaque nœud par la station connectée sur le nœud. La tension $V_a$ est appliquée au premier nœud du réseau. La tension $V_b$ est appliquée au deuxième nœud du réseau. La tension $V_c$ est appliquée au troisième nœud du réseau.

Une première liaison 11 relie le premier nœud au deuxième nœud. Une deuxième liaison 12 relie le premier nœud au troisième nœud. Une troisième liaison 13 relie le deuxième nœud au troisième nœud.

Chaque liaison pourra être formée d'une ligne aérienne, d'un câble ou de toute autre solution permettant de transporter du courant.

Comme déjà décrit ci-dessus, dans une configuration où les stations B et C fournissent de l'énergie sur le réseau maillé et où la station A reçoit cette énergie, les courants Ib et Ic peuvent disposer de deux chemins pour rejoindre la station A. Sur la figure 1, on ainsi trois courants $I_1$, $I_2$ et $I_3$ circulant sur chaque liaison du réseau.

La figure 4 représente un dispositif de contrôle de flux de puissance (pouvant être désigné ci-après dispositif) employé dans un réseau maillé, inséré dans une maille du réseau et formant un nœud entre trois liaisons du réseau. De manière générale, un tel dispositif comporte :

- Une première borne B1 destinée à être connectée à la première liaison, une deuxième borne B2 destinée à être connectée à la deuxième liaison et une troisième borne B3 destinée à être connectée à une autre liaison du réseau ;
- Au moins une source de tension insérée dans la maille ;
- Des moyens de commutation ;
- Des moyens de commande 21 desdits moyens de commutation configurés pour contrôler le flux de puissance et la répartition des courants dans la maille.

Partant de cette base, un dispositif de contrôle de flux de puissance peut se présenter suivant différentes variantes de réalisation décrites ci-dessous. Sur chacune des topologies représentées, les mêmes références sont employées. T désigne un transistor, D désigne une diode, Th désigne un thyristor, L désigne une inductance et C désigne un condensateur. Un indice (allant de 1 à n) différent est ajouté pour chaque composant du même type présent dans le dispositif, n étant le nombre total de chaque composant dans le circuit considéré.

**Figure 8A** :

Cette solution consiste en l'ajout d'une source de tension passive C1 (condensateur) en série avec la première liaison et la deuxième liaison en alternance, les moyens de commutation étant commandés de manière adaptée pour assurer cette alternance de connexion. Les moyens de commutation comportent des interrupteurs de puissance T1, T2 de type IGBT et sont réversibles en tension grâce à l'ajout d'une diode D1, D2 en série avec chaque interrupteur. Cette solution est décrite dans la demande de brevet n°EP3007301A1.

**Figure 9A** :

Cette solution repose également sur l'insertion d'une source de tension passive (condensateur C1) dans la maille. Les moyens de commutation comportent des interrupteurs (T1 à T6) de type IGBT organisés en trois bras de commutation connectés chacun en parallèle de la source de tension, chaque bras de commutation comprenant deux interrupteurs en série. Les interrupteurs sont réversibles en courant grâce à l'ajout d'une diode (D1 à D6) en parallèle de chaque interrupteur. Le point milieu du premier bras de commutation (T3, T4) est relié à la borne B1 du dispositif, le point milieu du deuxième bras de commutation (T5, T6) est relié à la borne B2 et le point milieu du troisième bras de commutation (T1, T2) est relié à la borne B3 du dispositif. Cette solution est décrite dans la demande de brevet n°US2015/180231A1.

**Figure 10A** :

Cette figure montre un dispositif de contrôle de flux de puissance de type "full-bridge" (T1 à T4) insérant une source de tension passive (condensateur C1). Les interrupteurs (thyristors Th1 à Th4) sont commandés pour configurer le dispositif en fonction des sens des courants $I_1$, $I_2$ et I. Dans cette réalisation, les commutateurs T1 à T4 sont réversibles en courant grâce à l'ajout d'une diode (D1 à D4) en parallèle. Cette solution est décrite dans la demande de brevet n°EP2975723A1 (également publiée sous le n°WO2016008927A1).

**Figure 11, Figure 11.1_A, Figure 11.2_A, Figure 11.3_A, Figure 11.4_A**

Il s'agit d'un dispositif extrait d'une demande de brevet non encore publiée. Le dispositif comporte deux sources de tension passives et une source de courant. La première source de tension est connectée entre sa première borne (B1) et sa troisième borne (B3) et la deuxième source de tension est connectée entre sa deuxième borne (B2) et sa troisième borne (B3). La source de courant est connectée alternativement à la première source de tension et à la deuxième source de tension grâce à des moyens de commutation commandés et permet d'assurer un transfert d'énergie entre la première source de tension et la deuxième source de tension. Des moyens de commande 21 sont configurés pour commander lesdits moyens de commutation de manière à réaliser ladite connexion de ladite source de courant en alternance, en parallèle de la première source de tension ou en parallèle de la deuxième source de tension et commander ainsi le transfert d'énergie entre la première source de tension et la deuxième source de tension via ladite source de courant.

La première source de tension peut comporter au moins un premier condensateur $C_1$ ayant une capacité déterminée.

La deuxième source de tension peut comporter au moins un deuxième condensateur $C_2$ ayant une capacité déterminée.

La source de courant peut comporter une inductance L.

Les deux condensateurs $C_1$, $C_2$ sont connectés tous deux à la troisième borne B3 du dispositif 20 et présentent leur autre borne connectée respectivement à la première borne B1 et à la deuxième borne B2 du dispositif de manière à venir se connecter aux deux liaisons 11, 12 dont on souhaite contrôler les courants ($I_1$, $I_2$).

En variante de réalisation, l'un des deux condensateurs ($C_1$, $C_2$) pourrait être connecté entre les bornes B1 et B2 alors que l'autre condensateur resterait connecté entre les bornes B1 et B3 ou B2 et B3.

La constitution des interrupteurs électroniques de puissance et leur arrangement dépendent d'une part des signes des courants ($I_1$ et $I_2$) qui circulent dans les liaisons, d'autre part du signe de la tension ($V_x = V_1 - V_2$) qui doit être insérée dans la maille dans laquelle on cherche à contrôler les courants. La structure des moyens de commutation est donc choisie en fonction du réseau dans lequel le dispositif sera inséré et des points de fonctionnement attendus.

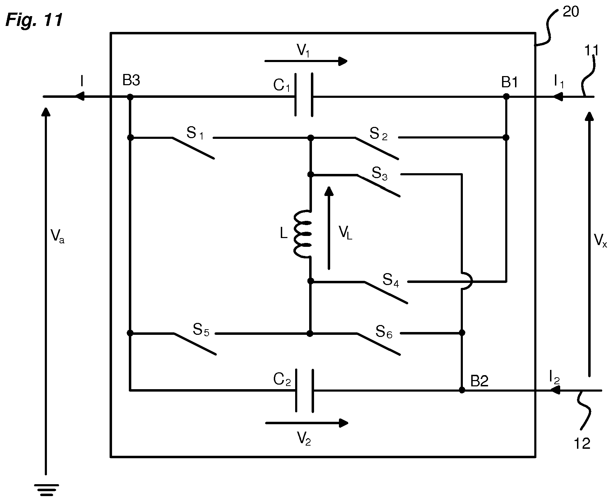

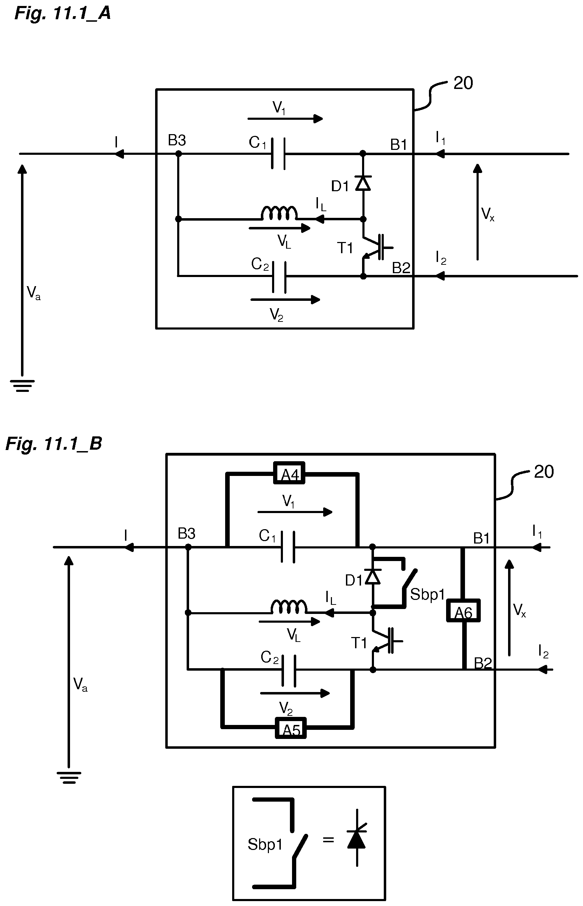

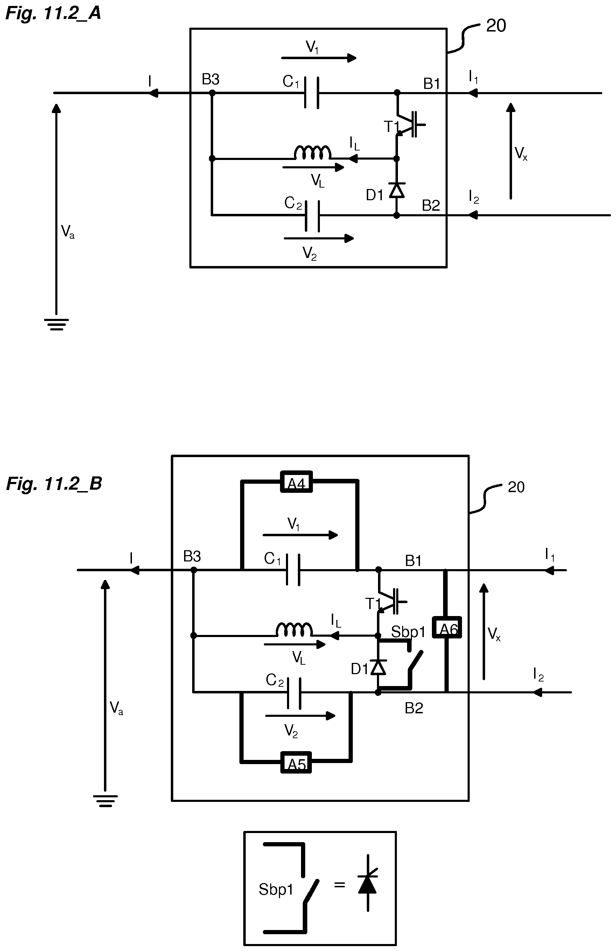

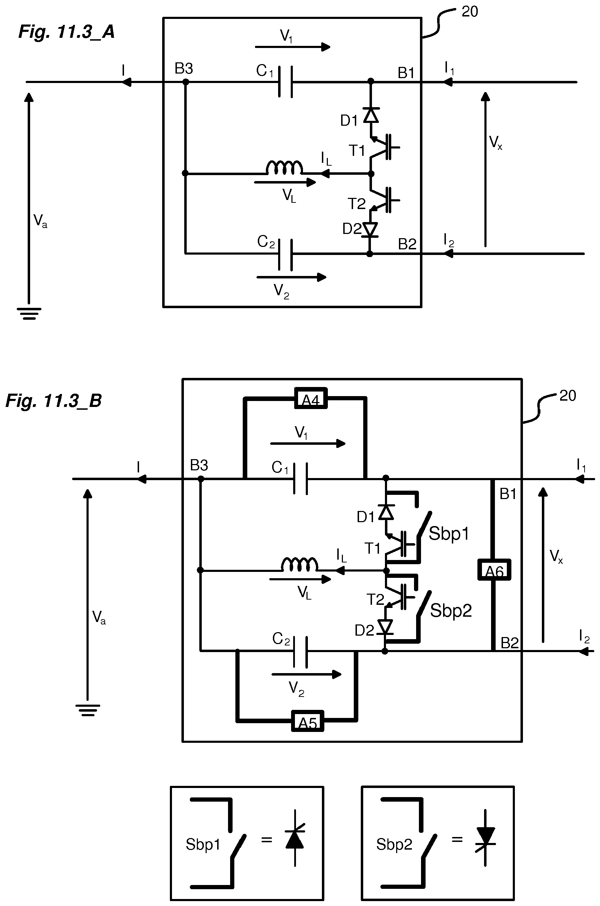

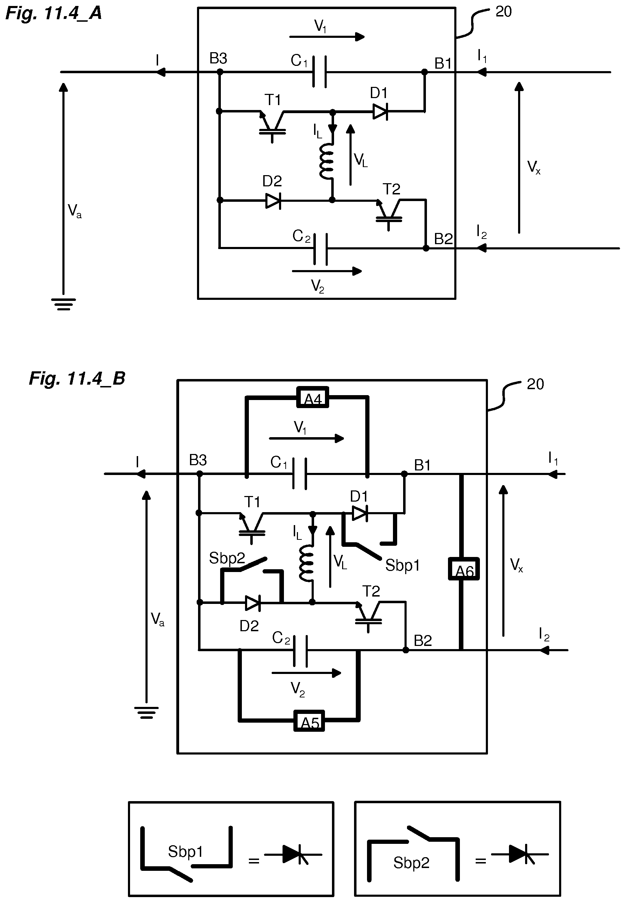

Dans l'architecture la plus générale du dispositif, représentée sur la figure 11, les moyens de commutation comportent six commutateurs :

- Un premier ensemble de deux commutateurs $S_1$, $S_2$ connectés entre la première borne B1 et la troisième borne B3 du dispositif 20 (en parallèle de la première source de tension, c'est-à-dire du premier condensateur $C_1$), les deux commutateurs $S_1$, $S_2$ définissant entre eux un premier point milieu de connexion ;

- Un deuxième ensemble de deux commutateurs $S_5$, $S_6$ connecté entre la deuxième borne B2 et la troisième borne B3 (en parallèle de la deuxième source de tension, c'est-à-dire du deuxième condensateur C2), les deux commutateurs $S_5$, $S_6$ définissant entre eux un deuxième point milieu de connexion ;

- Un commutateur $S_3$ connecté entre la deuxième borne B2 du dispositif 20 et le premier point milieu du premier ensemble de commutateurs ;

- Un commutateur $S_4$ connecté entre la première borne B1 du dispositif 20 et le deuxième point milieu du deuxième ensemble de commutateurs ;

Dans cette architecture générale, l'inductance L est connectée entre le premier point milieu et le deuxième point milieu.

Pour chaque commutateur, des moyens de commutation pourront ensuite être choisis en fonction du signe des valeurs suivantes :

- Le courant $I_1$ ;

- Le courant $I_2$ ;

- Le ratio $I_1/I_2$ ;

- La différence $I_1-I_2$ ;

- La différence $V_x=V_1-V_2$ ;

- Le ratio $\frac{V_1-V_2}{I_1+I_2}$ ;

- $I_1$ correspond au courant qui circule dans la première liaison ;

- $I_2$ correspond au courant qui circule dans la deuxième liaison ;

- V1 correspond à la tension aux bornes de la première source de tension ;

- V2 correspond à la tension aux bornes de la deuxième source de tension ;

Les signes de ces valeurs définissent ce qu'on appelle par la suite un "cas de fonctionnement". En outre, certains commutateurs définis dans l'architecture générale pourront être supprimés (circuit ouvert) ou remplacés par une connexion permanente en fonction du nombre de cas de fonctionnement désirés.

Dans chaque cas de fonctionnement, les commutateurs $S_1$ à $S_6$ sont choisis selon une réalisation particulière afin de répondre au besoin. De manière non exhaustive et non limitative, chaque commutateur sera alors choisi selon l'une des réalisations listées ci-dessous :

- Un circuit ouvert (c'est-à-dire aucune liaison électrique) ;

- Un court-circuit (c'est-à-dire une connexion permanente) ;

- Une diode ;

- Un interrupteur contrôlé non réversible (par exemple : IGBT ou BJT) ;

- Un interrupteur contrôlé réversible en courant (par exemple : IGBT avec diode en parallèle ou MOSFET) ;

- Un interrupteur contrôlé réversible en tension (Par exemple : IGBT et diode en série) ;

- Un interrupteur contrôlé réversible en courant et tension (Par exemple : deux IGBT avec diode en série) ;

- Un commutateur mécanique seul ;

- Un commutateur mécanique en série avec une diode ;

- Un commutateur mécanique en série avec un interrupteur contrôlé ;

- Eventuellement une combinaison de plusieurs de ces réalisations ;

Partant de ces principes, les figures 11.1_A, 11.2_A, 11.3_A, 11.4_A représentent plusieurs réalisations concrètes du dispositif générique de la figure 11.

**- Cas où $I_1<0$, $I_2<0$ et $V_x>0$ - Figure 11.1_A**

Dans cette réalisation, on a ainsi :

- $S_1$ = Circuit ouvert
- $S_2$ = Diode
- $S_3$ = IGBT
- $S_4$ = Circuit ouvert
- $S_5$ = Court-circuit
- $S_6$ = Circuit ouvert

**- Cas où $I_1>0$, $I_2>0$ et $V_x>0$ - Figure 11.2_A**

Dans cette réalisation, on a ainsi :

- $S_1$ = Circuit ouvert
- $S_2$ = IGBT
- $S_3$ = Diode
- $S_4$ = Circuit ouvert
- $S_5$ = Court-circuit
- $S_6$ = Circuit ouvert

**- Cas où $I_1<0$, $I_2<0$ et $V_x$ de signe quelconque (le signe de $V_x$ peut changer lors du fonctionnement) - Figure 11.3_A**

Dans cette réalisation, on a ainsi :

- $S_1$ = Circuit ouvert
- $S_2$ = IGBT + Diode
- $S_3$ = IBGT + Diode
- $S_4$ = Circuit ouvert
- $S_5$ = Court-circuit
- $S_6$ = Circuit ouvert

Pour ce besoin, les interrupteurs doivent être réversibles en tension. Ainsi, on utilisera des transistors en série avec des diodes ou des Thyristors GTO symétriques (qui supportent une tension inverse) ou IGCT symétriques.

**- Cas où $I_1<0$, $I_2>0$ et $V_x>0$ - Figure 11.4_A**

Dans cette réalisation, on a :

- $S_1$ = IGBT
- $S_2$ = Diode
- $S_3$ = Circuit ouvert
- $S_4$ = Circuit ouvert

- $S_5$ = Diode
- $S_6$ = IGBT

Le principe de l'invention consiste ainsi notamment à proposer un système incluant un dispositif de contrôle de flux de puissance tel que présenté ci-dessus et des moyens de protection de ce dispositif pour faire face à des défauts électriques, notamment les défauts qui sont dits externes et qui concernent les défauts issus du réseau DC lui-même, comme par exemple un défaut de type pôle-terre ou de type pôle-pôle. Il faut noter que certains défauts qualifiés d'externe peuvent bien entendu coïncider avec des défauts internes selon leur localisation par rapport aux composants du dispositif de contrôle de flux de puissance.

Les défauts de type pôle-terre sont indiqués sur la figure 4 et référencés X1, X2 et X3 pour chaque liaison à une borne B1, B2, B3 du dispositif. Lors d'un tel défaut, les composants du dispositif sont en effet soumis à des contraintes en courant et en tension importantes. Afin de ne pas obliger un surdimensionnement pour supporter ces contraintes, Il s'avère nécessaire de les protéger efficacement.

Le système de l'invention comporte principalement :

- Des moyens de protection adaptés à la topologie du dispositif de contrôle de flux de puissance ;
- Des moyens de mesure et de détection de défaut permettant de détecter la présence d'un défaut électrique ;
- Des moyens d'identification du défaut détecté, notamment lorsque celui-ci est de type externe (voir détails ci-dessous) ;
- Des moyens de commande configurés pour appliquer une séquence de commande adaptée au défaut identifié ;

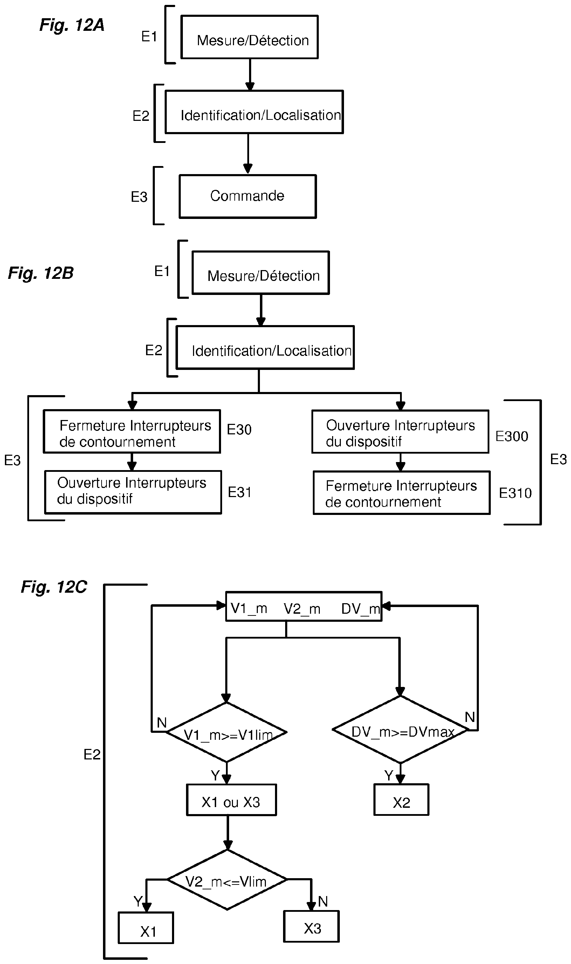

En référence à la figure 12A, pour mettre en œuvre une protection adaptée, le système met ainsi en œuvre les étapes suivantes :

- E1 : Mesure et détection du défaut ;
- E2 : Identification du défaut détecté ;
- E3 : Commande selon une séquence adaptée au défaut identifié ;

Pour la mise en œuvre de la première étape E1, les moyens de détection comportent des moyens de mesure de tension et/ou de courant et de leurs dérivées au niveau du dispositif. De manière non limitative, dans un dispositif tel que celui de la figure 11 et plus généralement pour les dispositifs à deux sources de tension, les moyens de détection peuvent comporter des moyens de mesure de la tension aux bornes de chaque source de tension ainsi que de leurs dérivées et des mesures de courant traversant les commutateurs ainsi que de leurs dérivées. Par exemple, la présence d'un défaut électrique est détectée lorsque la tension aux bornes d'une source de tension change de signe.

Les moyens d'identification sont quant à eux configurés pour localiser le défaut électrique détecté. L'identification réalisée à la deuxième étape E2 consiste donc à déterminer si le défaut est de type X1, X2 ou X3. L'étape d'identification E3 peut être effectuée grâce à une comparaison entre le signe des tensions aux bornes des sources de tension. Connaissant le signe de la tension avant défaut, les moyens d'identification peuvent localiser le défaut en fonction du signe de la tension après le défaut.

A titre d'exemple, dans le dispositif de la figure 11.1_A, le passage par zéro de la tension aux bornes du condensateur C1 montre que le défaut est de type X1 (initialement V1 est positive, passage à zéro pour devenir négative). Le tableau ci-dessous illustre la localisation des défauts pour un dispositif tel que celui de la **figure 11.1_A** :

| Tension | Initiale (avant défaut) | X1 | X2 | X3 |
|---------|-------------------------|----|----|----|
| V1 | + | - | + | + |
| V2 | - | + | - | + |

En variante de réalisation ou en complément au principe de détection par changement de signe de la tension, la surveillance de la dérivée d'une tension permet également de détecter la présence d'un défaut. Par exemple, si une tension positive est mesurée et qu'elle diminue, il est possible de détecter la présence du défaut avant que celle-ci ait changé de signe.

Une fois le défaut identifié lors de la deuxième étape E2, il s'agit, lors de la troisième étape E3, d'exécuter une séquence de commande adaptée au défaut identifié. Selon un aspect particulier de l'invention, le système comporte ainsi des moyens de commande destinés à commander les interrupteurs de contournement employés dans les moyens de protection et des interrupteurs ou commutateurs du dispositif de contrôle de flux de puissance selon la séquence de commande utilisée.

La séquence de commande mise en œuvre pour réaliser la protection repose sur les deux principes suivants :

- Le courant ne doit pas être interrompu dans des inductances du dispositif de contrôle de flux de puissance, si celui-ci en comporte.
- Les condensateurs du dispositif de contrôle de flux de puissance ne doivent pas être court-circuités.

En liaison avec la figure 12B, deux séquences de commande générales distinctes peuvent ainsi être envisagées :

Etapes E30 + E31 : La séquence peut consister de manière générale à fermer les interrupteurs de contournement aux bornes des interrupteurs fermés au moment de la détection du défaut (E30) puis à ouvrir les interrupteurs adéquats du dispositif de contrôle de flux de puissance, selon la configuration du dispositif de contrôle de flux de puissance (E31).

Etapes E300 + E310 : La séquence peut consister à ouvrir les interrupteurs adéquats du dispositif de contrôle de flux de puissance (E300) puis à fermer les interrupteurs de contournement adéquats des moyens de protection (E310).

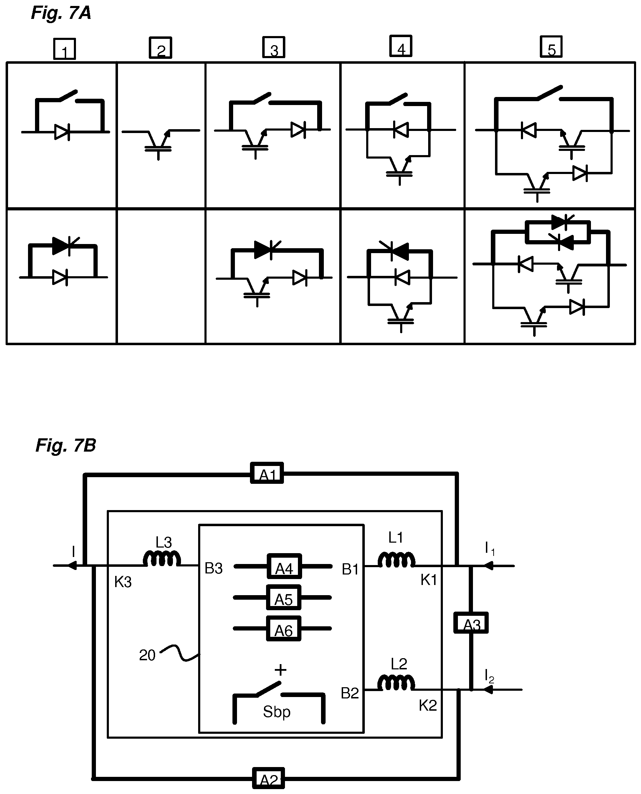

Les figures 7A et 7B illustrent le principe mis en œuvre pour réaliser des moyens de protection adaptés à un dispositif de contrôle de flux de puissance employé dans un réseau maillé et comportant au moins une source de tension.

Il s'agit en effet de considérer chaque composant du dispositif et, si nécessaire, de le protéger de manière adaptée.

Les moyens de protection peuvent inclure :

- Au moins des dispositifs de limitation de tension (connectés aux bornes des sources de tension (parafoudres A4, A5) et éventuellement aux bornes du dispositif de contrôle de flux de puissance dans sa totalité (parafoudre A6) ;
- D'un interrupteur (Sbp) ou d'un groupement d'interrupteurs de contournement agencés pour court-circuiter les commutateurs du dispositif afin de les protéger en courant ;
- Des dispositifs de limitation de la variation de courant (di/dt) (inductance L1, L2, L3), si besoin, par exemple dans le cas où le dispositif de contrôle de flux de puissance lui-même n'en disposerait pas ;
- Et éventuellement des dispositifs de limitation en tension (parafoudres A1, A2, A3) ;

De manière plus précise, en relation avec la figure 7A, les moyens de protection comportent :

- Pour chaque diode du dispositif, un interrupteur de contournement placé en parallèle de la diode (colonne 1 sur la figure 7A) ;
- Pour chaque commutateur de type interrupteur contrôlé réversible en tension uniquement, un interrupteur de contournement placé en parallèle du commutateur (colonne 3 sur la figure 7A) ;
- Pour chaque commutateur de type interrupteur contrôlé réversible en courant uniquement, un interrupteur de contournement placé en parallèle du commutateur (colonne 4 sur la figure 7A) ;
- Pour chaque commutateur de type interrupteur contrôlé réversible en courant et en tension, un interrupteur de contournement placé en parallèle du commutateur (colonne 5 sur la figure 7A) ;

De manière non limitative mais avantageuse, chaque interrupteur de contournement Sbp est choisi parmi un thyristor, deux thyristors connectés tête-bêche et un ensemble de thyristors connectés en parallèle et/ou en série. Toute autre solution de commutation pourra cependant être envisagée.

Les thyristors présentent l'avantage de supporter de fortes surcharges en courant pendant de courtes durées et de pouvoir être fermés beaucoup plus rapidement que des interrupteurs mécaniques. Pour la réalisation de la fonction, on pourra également utiliser un ensemble formé d'un thyristor et d'un contact mécanique connecté en parallèle, ce dernier ayant un temps de fermeture plus long mais une capacité à supporter un courant de défaut pendant une durée plus longue.

Il faut noter que si le commutateur est de type interrupteur contrôlé non réversible, il ne nécessite pas nécessairement de protection particulière en courant (colonne 2 sur la figure 7A). Dans un dispositif qui utilise un interrupteur contrôlé non réversible, son ouverture provoque la commutation du courant vers une diode. Dès que le défaut est détecté par l'un des moyens énoncés plus haut, par exemple son courant qui dépasse la valeur admissible pour l'interrupteur contrôlé non réversible, celui-ci doit être ouvert. Le courant circule alors dans la diode qui doit alors être protégée contre les surcharges en courant.

Il faut noter que si le commutateur est de type interrupteur non contrôlé et non réversible (colonne 1 sur la figure 7A), la fermeture de l'interrupteur de contournement Sbp protège en courant ce type d'interrupteur.

Il faut noter que si le commutateur est de type interrupteur contrôlé et réversible en tension (colonne 3 sur la figure 7A), la fermeture de l'interrupteur de contournement Sbp protège en courant ce type d'interrupteur.

Il faut noter que si le commutateur est de type interrupteur contrôlé et réversible en courant (colonne 4 sur la figure 7A), la fermeture de l'interrupteur de contournement Sbp protège en courant ce type d'interrupteur.

Le principe de base ici, repose sur le fait qu'on vise à offrir un chemin alternatif au courant de défaut plutôt que de l'interrompre ou le couper. Et tout ceci, en s'assurant que les commutateurs de type interrupteur contrôlé soient ouverts et les commutateurs de type interrupteur non contrôlé soient protégés par un interrupteur de contournement.

Chaque dispositif de limitation en tension A1, A2, A3, A4,.., An peut comporter au moins un parafoudre et/ou un parafoudre en série avec un éclateur ou tout autre dispositif de limitation de tension.

Le système peut comporter trois bornes (K1, K2, K3), une première borne (K1) reliée à ladite première borne (B1) du dispositif de contrôle de flux de puissance, une deuxième borne (K2) reliée à ladite deuxième borne (B2) du dispositif de contrôle de flux de puissance, une troisième borne (K3) reliée à ladite troisième borne (B3) du dispositif de contrôle de flux de puissance.

De manière plus précise, en relation avec la figure 7B, selon la topologie du dispositif de contrôle de flux de puissance, les moyens de protection employés dans le système pourront être les suivants :

- Parafoudre A4 connecté en parallèle d'une première source de tension et parafoudre A5 connecté en parallèle d'une deuxième source de tension,
- Parafoudre A6 connecté en parallèle du dispositif de contrôle de flux de puissance, entre les bornes B1 et B2,
- Eventuellement des inductances L1, L2 ou L3 connectées chacune entre une borne K1, K2, K3 du système et chaque borne B1, B2, B3 correspondante du dispositif de contrôle de flux de puissance,
- Parafoudre A1 connecté entre les deux bornes K1, K3 du système,
- Parafoudre A2 connecté entre les deux bornes K2, K3 du système,
- Parafoudre A3 connecté entre les deux bornes K1, K2 du système,
- Interrupteurs de contournement Sbp selon le tableau de la figure 7A.

Il faut noter qu'il existe plusieurs arrangements possibles pour les dispositifs de limitation de la variation de courant (inductances L1, L2, L3). Dans la majorité des cas, les deux inductances L1 et L2 en série avec les deux bornes B1, B2 du dispositif peuvent suffire. La troisième inductance L3 est optionnelle et permet une répartition différente des valeurs des inductances.

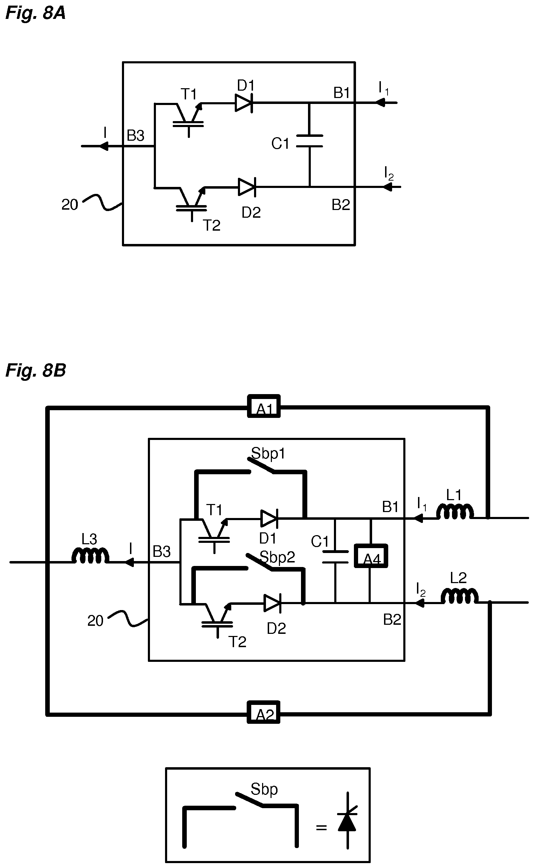

Ces principes et moyens de protection peuvent ainsi être appliqués sur les différentes topologies des dispositifs décrits ci-dessus et représentés sur les figures 8A à 11.4_A.

La figure 8B représente ainsi le dispositif de la figure 8A sur lequel ont été ajoutés les moyens de protection adaptés, selon les correspondances définies ci-dessus. On a ainsi :

- Un thyristor ou ensemble de thyristors (représenté sous la forme d'un interrupteur Sbp1, Sbp2) connecté en parallèle de chaque commutateur ;
- Un dispositif de limitation de type parafoudre (A4) aux bornes de la source de tension ;
- Eventuellement un dispositif de limitation de la variation de courant (inductances L1, L2, optionnellement L3) en série avec chaque borne du dispositif ;
- Des dispositifs de limitation de tension de type parafoudre entre les bornes des inductances (A1 en parallèle de L1 et L3 et A2 en parallèle de L2 et L3) ;

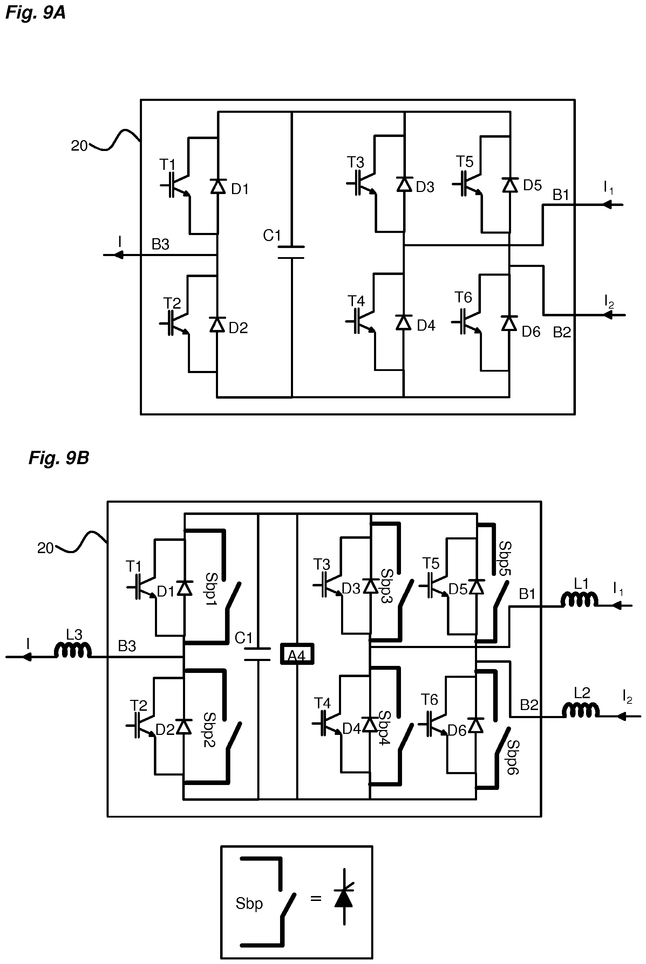

La figure 9B représente ainsi le dispositif de la figure 9A sur lequel ont été ajoutés les moyens de protection adaptés, selon les correspondances définies ci-dessus. On a ainsi :

- Un thyristor ou un ensemble de thyristors (Sbp1-Sbp6) connecté en parallèle de chaque commutateur ;
- Un dispositif de limitation de type parafoudre (A4) aux bornes de la source de tension ;
- Et éventuellement, un dispositif de limitation de la variation de courant (inductances L1, L2, optionnellement L3) en série avec chaque borne du dispositif.

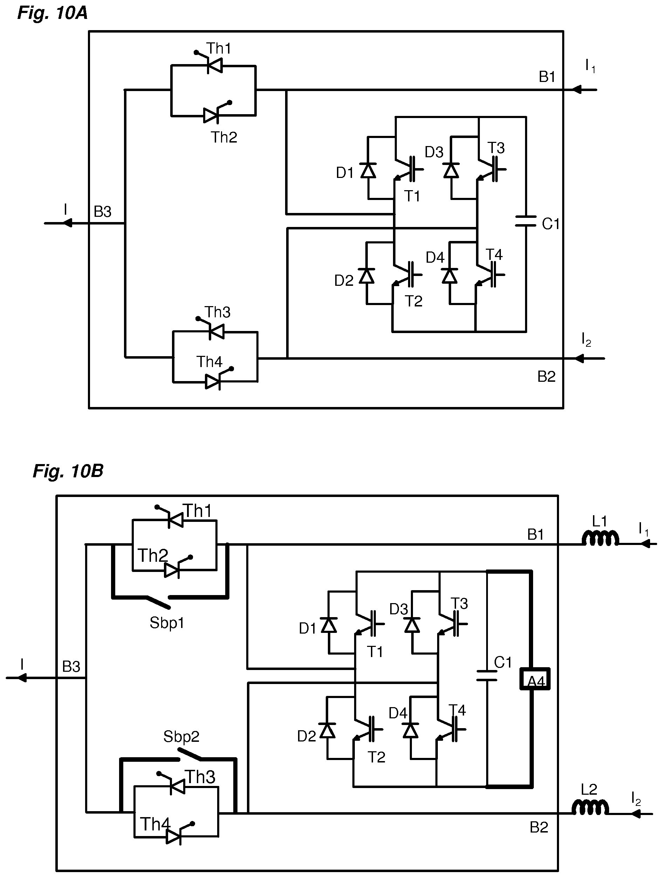

La figure 10B représente ainsi le dispositif de la figure 10A sur lequel ont été ajoutés les moyens de protection adaptés, selon les correspondances définies ci-dessus. On a ainsi :

- Un interrupteur de contournement (Sbp1, Sbp2) de type mécanique connecté en parallèle de chaque commutateur (formé chacun de deux thyristors Th1, Th2 et Th3, Th4) ;
- Un dispositif de limitation de type parafoudre (A4) aux bornes de la source de tension ;
- Et éventuellement, un dispositif de limitation de la variation de courant (inductances L1, L2, optionnellement L3 (non représentée)) en série avec chaque borne du dispositif.

La figure 11.1_B représente ainsi le dispositif de la figure 11.1_A sur lequel ont été ajoutés les moyens de protection adaptés, selon les correspondances définies ci-dessus. On a ainsi :

- Un thyristor ou un ensemble de thyristors (Sbp1) connecté en parallèle de la diode D1 ;
- Un parafoudre (A4, A5) connecté en parallèle de chaque source de tension, c'est-à-dire en parallèle de chaque condensateur C1, C2 ;
- Un parafoudre (A6) connecté entre les deux bornes B1 et B2 du dispositif de contrôle de flux de puissance ;
- Eventuellement, un dispositif de limitation de la variation de courant (inductances non représentées) en série avec chaque borne du dispositif.

La figure 11.2_B représente ainsi le dispositif de la figure 11.2_A sur lequel ont été ajoutés les moyens de protection adaptés, selon les correspondances définies ci-dessus. On a ainsi :

- Un thyristor ou un ensemble de thyristors (Sbp1) connecté en parallèle de la diode D1 ;
- Un parafoudre (A4, A5) connecté en parallèle de chaque source de tension, c'est-à-dire en parallèle de chaque condensateur C1, C2;
- Un parafoudre (A6) connecté entre les deux bornes B1 et B2 du dispositif de contrôle de flux de puissance ;
- Eventuellement un dispositif de limitation de la variation de courant (inductances non représentées) en série avec chaque borne du dispositif.

La figure 11.3_B représente ainsi le dispositif de la figure 11.3_A sur lequel ont été ajoutés les moyens de protection adaptés, selon les correspondances définies ci-dessus. On a ainsi :

- Un thyristor ou un ensemble de thyristors (Sbp1, Sbp2) connecté en parallèle de chaque commutateur de type interrupteur contrôlé réversible en tension (IGBT+diode en série), orienté dans le même sens que la diode ;
- Un parafoudre (A4, A5) connecté en parallèle de chaque source de tension, c'est-à-dire en parallèle de chaque condensateur ;
- Un parafoudre (A6) connecté entre les deux bornes B1 et B2 du dispositif de contrôle de flux de puissance ;
- Eventuellement un dispositif de limitation de la variation de courant (inductances non représentées) en série avec chaque borne du dispositif.

La figure 11.4_B représente ainsi le dispositif de la figure 11.4_A sur lequel ont été ajoutés les moyens de protection adaptés, selon les correspondances définies ci-dessus. On a ainsi :

- Un thyristor ou un ensemble de thyristors (Sbp1, Sbp2) connecté en parallèle de chaque diode D1, D2 ;
- Un parafoudre (A4, A5) connecté en parallèle de chaque source de tension, c'est-à-dire en parallèle de chaque condensateur ;
- Un parafoudre (A6) connecté entre les deux bornes B1 et B2 du dispositif de contrôle de flux de puissance ;
- Eventuellement, un dispositif de limitation de la variation de courant (inductances non représentées) en série avec chaque borne du dispositif.

La figure 12C représente un algorithme d'identification, pouvant être employé pour identifier un défaut dans un réseau contrôlé par un dispositif à deux sources de tension telque celui de la figure 11. Cet algorithme peut être exécuté lors de la deuxième étape E2 évoquée ci-dessus en liaison avec les figures 12A et 12B.
L'algorithme se base sur les mesures de la tension aux bornes du condensateur C1 et de la tension aux bornes du condensateur C2.
Dans cet algorithme de la figure 12C, on a :

- Une étape de comparaison de la tension V1_m mesurée aux bornes du condensateur C1 par rapport à V1lim, une valeur seuil prédéfinie.
- Si la tension V1_m est supérieure ou égale à V1lim et devient positive (elle était initialement négative), le défaut est alors de type X1 ou X3.
- Une deuxième étape de comparaison de la tension V2_m mesurée aux bornes du condensateur C2 par rapport à V2lim, une valeur seuil prédéfinie.
- Si la tension V2_m est inférieure ou égale à V2lim, le défaut est de type X1.
- Si la tension V2_m est supérieure à V2lim, le défaut est de type X3.

- En parallèle, une étape de comparaison de la différence de tension DV_m aux bornes du dispositif de contrôle de flux de puissance par rapport à une valeur seuil DVmax.
- Si la valeur seuil DVmax est dépassée, le défaut est de type X2.

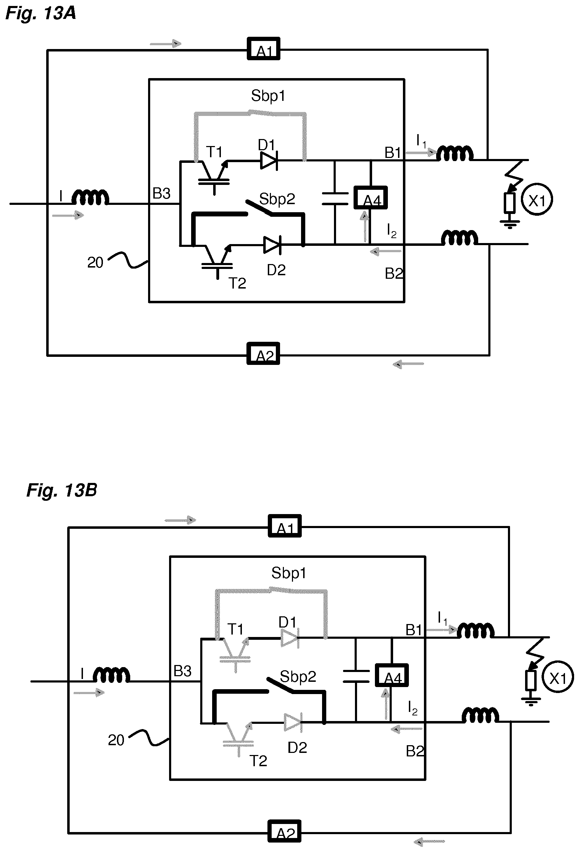

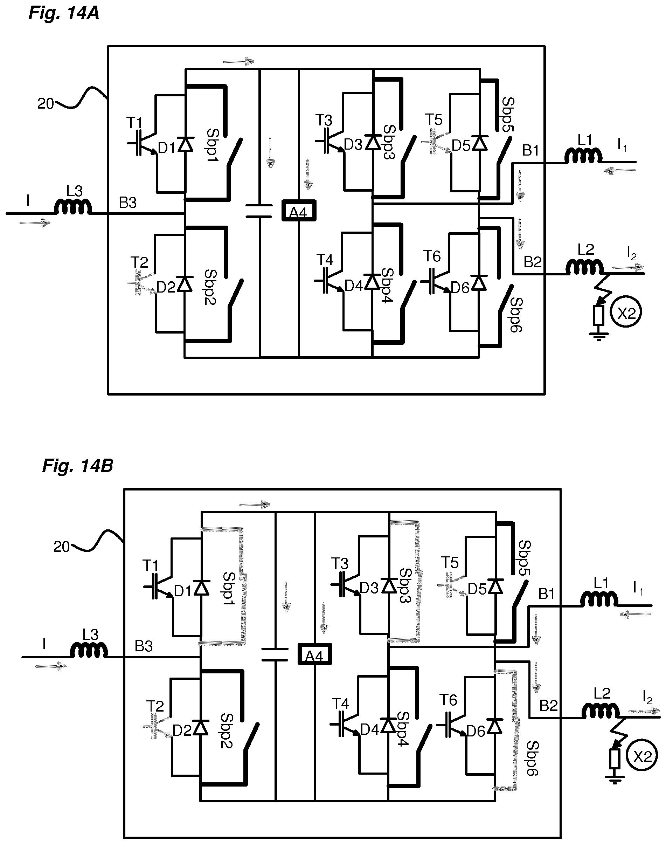

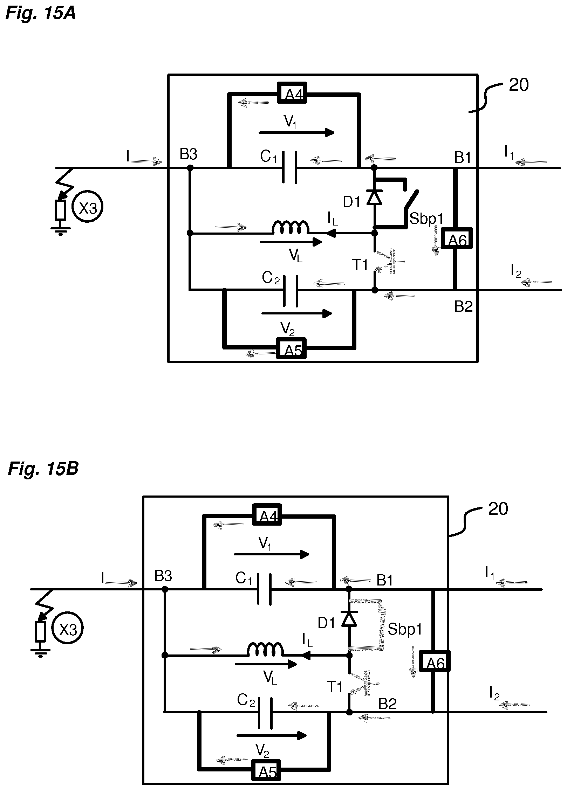

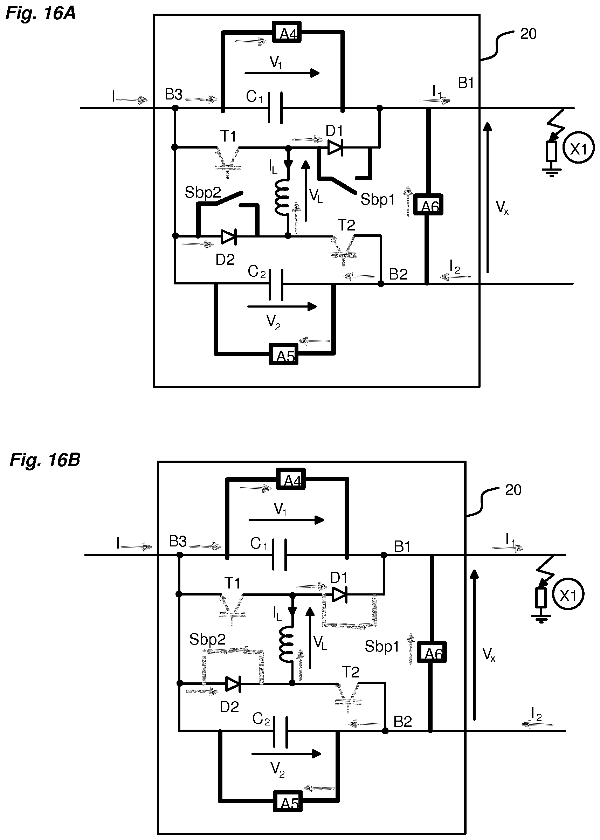

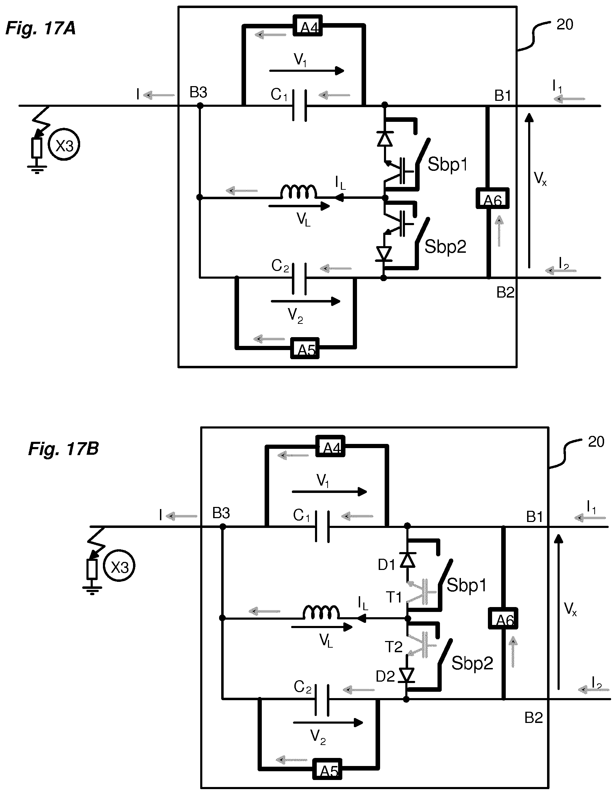

De manière plus précise, les moyens de commande peuvent disposer de plusieurs séquences de commande distinctes, selon les différents types de défaut. Sur les figures 13A à 17B, différentes séquences de commande sont illustrées. Les traits grisés montrent les différentes actions entreprises ainsi que le sens du courant dans le dispositif de contrôle de flux de puissance utilisé. Bien entendu, ces séquences sont à considérer de manière non limitative et d'autres variantes de fonctionnement peuvent bien entendu être mises en œuvre.

**Figures 13A et 13B** :

Lorsque le défaut présent est de type X1, dans le cas du dispositif de contrôle de flux de puissance de la figure 8B, la séquence de commande est la suivante :

Etape 1 : Détection/identification du défaut selon les principes évoqués ci-dessus.
Etape 2 : Si Tx (x=1 ou x=2) conduit, fermer l'interrupteur de contournement Sbpx.
Etape 3 : Ouvrir le transistor Tx (et laisser l'autre transistor ouvert).

**Figures 14A et 14B** :

Lorsque le défaut présent est de type X2, la séquence de commande pour le dispositif de contrôle de flux de puissance de la figure 9B, utilisé ici dans une configuration de fonctionnement donné, est la suivante :

Etape 1 : Détection/identification du défaut selon les principes évoqués ci-dessus.
Etape 2 : Ouvrir le transistor T2 et le transistor T5 qui étaient fermés en fonctionnement normal.
Etape 3 : Fermer les interrupteurs de contournement Sbp1, Sbp3 et Sbp6.

**Figures 15A et 15B** :

Lorsque le défaut présent est de type X3, la séquence de commande pour le dispositif de contrôle de flux de puissance de la figure 11.1B est la suivante :

Etape 1 : Détection/identification du défaut selon les principes évoqués ci-dessus.
Etape 2 : Ouvrir le transistor T1.
Etape 3 : Fermer l'interrupteur Sbp1 (optionnel, car dans ce cas, le courant dans l'inductance décroit).

**Figures 16A et 16B** :

Lorsque le défaut présent est de type X1, la séquence de commande pour le dispositif de contrôle de flux de puissance de la figure 11.4B est la suivante :

> Etape 1 : Détection/identification du défaut selon les principes évoqués ci-dessus.
> Etape 2 : Ouvrir les transistors T1 et T2.
> Etape 3 : Fermer les interrupteurs Sbp1 et Sbp2.

**Figures 17A et 17B** :

Lorsque le défaut présent est de type X3, la séquence de commande pour le dispositif de contrôle de flux de puissance de la figure 11.3B est la suivante :

> Etape 1 : Détection/identification du défaut selon les principes évoqués ci-dessus.
> Etape 2 : Pour annuler le courant, fermer le transistor T2 si la tension V2 est positive ou fermer le transistor T1 si la tension V1 est positive.

On comprend de ce qui précède que la solution proposée réduit parfaitement les contraintes physiques. Elle est simple à la réalisation et nécessite des éléments de protection standards en tension et en courant comme des parafoudres et/ou des éclateurs et/ou des inductances et des thyristors.

La solution proposée est "indépendante" du réseau dans lequel est inséré le dispositif car elle fournit une protection intrinsèque indépendante du système de protection du réseau global. Cela représente un intérêt majeur notamment lorsque le dispositif est installé après l'installation du réseau.

Dans le cas où, le système de protection du réseau suffirait à protéger le dispositif, la solution proposée pourrait aussi jouer le rôle de solution de secours.

La solution proposée (arrangement des éléments physiques et l'algorithme de protection associé) est générique et applicable à l'ensemble de la famille de dispositifs de contrôle de flux de puissance munis de sources de tension et/ou de sources de courants, dont certains ont été décrits ci-dessus et représentés sur les figures 8 à 11.

La solution proposée permet la détection et la localisation de défaut et dans certains cas applicatifs notamment avec deux sources de tension, elle propose une méthode de localisation du défaut dans le réseau global. Cette information peut être communiquée au système de protection global du réseau.

**Revendications**

1. Système destiné à être employé dans un réseau maillé, une maille comportant au moins trois nœuds chacun à une tension déterminée, ledit système comportant un dispositif de contrôle de flux de puissance agencé pour contrôler le flux de puissance dans la maille et qui comporte une première borne (B1) destinée à être connectée à une première liaison de la maille, une deuxième borne (B2) destinée à être connectée à une deuxième liaison de la maille et une troisième borne (B3) destinée à être connectée à une liaison du réseau, au moins une source de tension passive, des moyens de commutation connectés à ladite source de tension passive et des moyens de commande configurés pour commander lesdits moyens de commutation pour assurer une répartition des courants dans lesdites deux liaisons de la maille, ledit dispositif comprenant plusieurs diodes et lesdits moyens de commutation comprenant plusieurs commutateurs choisis parmi :

> - Un interrupteur contrôlé non réversible ;
> - Un interrupteur contrôlé réversible en courant ;
> - Un interrupteur contrôlé réversible en tension ;
> - Un interrupteur contrôlé réversible en courant et en tension ;
> - Un commutateur mécanique ;
> - Un commutateur mécanique connecté en série avec une diode ;
> - Un commutateur mécanique connecté en série avec un interrupteur contrôlé ;

Le système comprenant des moyens de détection d'un défaut électrique au sein du dispositif et des moyens d'identification du type de défaut électrique détecté,
Ledit système étant **caractérisé en ce qu'**il comporte des moyens de protection dudit dispositif de contrôle de flux de puissance, lesdits moyens de protection comprenant :

> - Un interrupteur de contournement placé en parallèle de chaque diode du dispositif de contrôle de flux de puissance ;
> - Un interrupteur de contournement placé en parallèle de chaque commutateur du dispositif de contrôle de flux de puissance, hormis si le commutateur est un interrupteur contrôlé non réversible ;
> - Un dispositif de limitation de tension connecté aux bornes de chaque source de tension passive ;

Et **en ce qu'**il comporte des moyens de commande de chaque interrupteur de contournement et de chaque moyen de commutation du dispositif de contrôle de flux de puissance selon une séquence de commande adaptée au type de défaut électrique identifié.

2. Système selon la revendication 1, **caractérisé en ce que** chaque interrupteur de contournement comporte un thyristor, deux thyristors connectés en tête bêche ou un groupement de thyristors connectés en parallèle et/ou en série.

3.  Système selon la revendication 1 ou 2, **caractérisé en ce que** chaque dispositif de limitation de tension comporte au moins un parafoudre.

4.  Système selon l'une des revendications 1 à 3, **caractérisé en ce qu'**il comporte au moins un dispositif de limitation de tension connecté entre au moins deux bornes du dispositif de contrôle de flux de puissance.

5.  Système selon l'une des revendications 1 à 4, **caractérisé en ce qu'**il comporte trois bornes (K1, K2, K3), une première borne (K1) reliée à ladite première borne (B1) du dispositif de contrôle de flux de puissance, une deuxième borne (K2) reliée à ladite deuxième borne (B2) du dispositif de contrôle de flux de puissance, une troisième borne (K3) reliée à ladite troisième borne (B3) du dispositif de contrôle de flux de puissance et **en ce qu'**il comporte au moins un dispositif de limitation de variation de courant connecté entre l'une de ses trois bornes (K1, K2, K3) et la borne correspondante du dispositif de contrôle de flux de puissance.

6.  Système selon la revendication 5, **caractérisé en ce qu'**il comporte au moins un dispositif de limitation de tension connecté entre deux de ses trois bornes.

7.  Système selon l'une des revendications 1 à 6, **caractérisé en ce que** ledit dispositif de contrôle de flux de puissance est **caractérisé en ce qu'**il comporte :

    - Une première source de tension connectée entre sa première borne (B1) et sa troisième borne (B3),
    - Une deuxième source de tension connectée entre sa deuxième borne (B2) et sa troisième borne (B3),
    - Une source de courant connectée alternativement à la première source de tension et à la deuxième source de tension et configurée pour assurer un transfert d'énergie entre la première source de tension et la deuxième source de tension,
    - Lesdits moyens de commutation étant configurés pour permettre une connexion de ladite source de courant en alternance, en parallèle de la première source de tension ou en parallèle de la deuxième source de courant,
    - Lesdits moyens de commande (21) étant configurés pour commander lesdits moyens de commutation de manière à réaliser ladite connexion de ladite source de courant en alternance, en parallèle de la première source de tension ou en parallèle de la deuxième source de courant et commander un transfert d'énergie entre la première source de tension et la deuxième source de tension via ladite source de courant.

8.  Système selon la revendication 7, **caractérisé en ce que** la première source de tension comporte au moins un condensateur (C1).

9.  Système selon la revendication 7 ou 8, **caractérisé en ce que** la deuxième source de tension comporte au moins un condensateur (C2).

10. Système selon l'une des revendications 7 à 9, **caractérisé en ce que** la source de courant comporte au moins une inductance (L).

11. Système selon la revendication 10, **caractérisé en ce que** les moyens de commutation comportent six commutateurs :

    - Un premier ensemble de deux premiers commutateurs $(S_1, S_2)$ connecté entre la première borne (B1) et la troisième borne (B3) du dispositif, en parallèle de la première source de tension, les deux commutateurs $(S_1, S_2)$ du premier ensemble définissant entre eux un premier point milieu de connexion ;
    - Un deuxième ensemble de deux deuxièmes commutateurs $(S_5, S_6)$ connecté entre la deuxième borne (B2) et la troisième borne (B3), en parallèle de la deuxième source de tension, les deux commutateurs $(S_5, S_6)$ du deuxième ensemble définissant entre eux un deuxième point milieu de connexion ;
    - Un troisième commutateur $(S_3)$ connecté entre la deuxième borne (B2) et le premier point milieu du premier ensemble de commutateurs ;
    - Un quatrième commutateur $(S_4)$ connecté entre la première borne (B1) et le deuxième point milieu du deuxième ensemble de commutateurs.

12. Système selon la revendication 11, **caractérisé en ce que** l'inductance (L) est connectée entre le premier point milieu et le deuxième point milieu.

13. Système selon la revendication 11 ou 12, **caractérisé en ce que** chaque commutateur est choisi en fonction du signe des paramètres suivants :

    - Le courant $I_1$ ;
    - Le courant $I_2$ ;
    - Le ratio $I_1/I_2$ ;
    - La différence $I_1-I_2$ ;
    - La différence $V_x=V_1-V_2$ ;

$$\frac{V_1 - V_2}{I_1 + I_2}$$
- Le ratio ;

Dans lesquelles :

- I$_1$ correspond au courant qui circule dans la première liaison ;
- I$_2$ correspond au courant qui circule dans la deuxième liaison ;
- V1 correspond à la tension aux bornes de la première source de tension ;
- V2 correspond à la tension aux bornes de la deuxième source de tension.

14. Système selon la revendication 13, **caractérisé en ce que** chaque commutateur est choisi parmi :

- Un circuit ouvert ;
- Un court-circuit ;
- Une diode ;
- Un interrupteur contrôlé non réversible ;
- Un interrupteur contrôlé réversible en courant ;
- Un interrupteur contrôlé réversible en tension ;
- Un interrupteur contrôlé réversible en courant et en tension ;
- Un commutateur mécanique seul ;
- Un commutateur mécanique en série avec une diode ;
- Un commutateur mécanique en série avec un interrupteur contrôlé ;

15. Système selon l'une des revendications 1 à 6, **caractérisé en ce que** ledit dispositif de contrôle de flux de puissance comporte une source de tension et **en ce que** les moyens de commutation comportent des interrupteurs (T1-T6) organisés en trois bras de commutation connectés chacun en parallèle de la source de tension, chaque bras de commutation comprenant deux interrupteurs en série, le point milieu du premier bras de commutation étant relié à la première borne (B1) du dispositif, le point milieu du deuxième bras de commutation étant relié à la deuxième borne (B2) et le point milieu du troisième bras de commutation étant relié à la troisième borne (B3) du dispositif.

**Patentansprüche**

1. System zur Verwendung in einem Maschennetz, wobei eine Masche mindestens drei Knoten mit jeweils einer bestimmten Spannung aufweist, wobei das System eine Leistungsfluss-Steuervorrichtung aufweist, die zur Steuerung des Leistungsflusses in der Masche angeordnet ist und einen ersten Anschluss (B1) aufweist, der mit einer ersten Verbindung der Masche angeschlossen werden soll, einen zweiten Anschluss (B2), der mit einer zweiten Verbindung der Masche angeschlossen werden soll, und einen dritten Anschluss (B3), der mit einer Verbindung des Netzwerks angeschlossen werden soll, eine passive Spannungsquelle, mit der passiven Spannungsquelle angeschlossene Schalt- und Steuerungsmittel, die so gestaltet ist, dass sie die Schaltmittel regelt, um eine Verteilung der Ströme in den beiden Verbindungen des Netzwerks zu gewährleisten, wobei die Vorrichtung mehrere Dioden und Schaltmittel umfasst, die mehrere Schalter umfasst, die ausgewählt sind aus:

- einem nicht brückend gesteuerten Schalter;
- einem brückenden stromgesteuerten Schalter;
- einem brückenden spannungsgesteuerten Schalter;
- einem brückenden strom- und spannungsgesteuerten Schalter;
- einem mechanischen Schalter;
- einem mechanischen Schalter, der mit einer Diode in Reihe zugeschaltet ist;
- einem mechanischer Schalter, der mit einem gesteuerten Schalter in Reihe zugeschaltet ist;

Das System umfasst Mittel zum Erfassen eines elektrischen Fehlers innerhalb der Vorrichtung und Mittel zur Erkennung der Art des erfassten elektrischen Fehlers.

Das erwähnte System ist **dadurch gekennzeichnet, dass** es Mittel zum Schutz der Vorrichtung zur Steuerung des Leistungsflusses enthält, wobei die erwähnten Schutzmittel umfassen:

- ein Bypass-Schalter, der parallel zu jeder Diode der Vorrichtung zur Steuerung des Leistungsflusses angeordnet ist;
- ein Bypass-Schalter, der parallel zu jedem Schalter der Vorrichtung zur Steuerung des Leistungsflusses angeordnet ist, außer wenn der Schalter ein nicht brückend geregelter Schalter ist;
- eine Spannungsbegrenzungsvorrichtung, die mit den Anschlüssen jeder passiven Spannungsquelle angeschlossen ist;

Und dass sie Mittel zur Steuerung jedes Bypass-Schalters und jedes Schaltmittels der Vorrichtung zur Steuerung des Leistungsflusses gemäß einer an die Art des erkannten elektrischen Fehlers angepassten Befehlssequenz umfasst.

2. System nach Anspruch 1, **dadurch gekennzeichnet, dass** jeder Bypass-Schalter einen Thyristor, zwei kopfseitig angeschlossenen Thyristoren oder eine Gruppe von Thyristoren enthält, die parallel und/oder in Serie angeschlossen sind.

3. System nach Anspruch 1 oder 2, **dadurch gekennzeichnet, dass** jede Spannungsbegrenzungsvorrichtung mindestens einen Überspannungsschutz enthält.

4. System nach einem der Ansprüche 1 bis 3, **dadurch gekennzeichnet, dass** es mindestens eine Spannungsbegrenzungsvorrichtung umfasst, die zwischen mindestens zwei Anschlüssen der Vorrichtung zur Steuerung des Leistungsflusses angeschlossen ist.

5. System nach einem der Ansprüche 1 bis 4, **dadurch gekennzeichnet, dass** es drei Klemmen (K1, K2, K3) umfasst, eine erste Klemme (K1), der mit der ersten Klemme (B1) der Vorrichtung zur Steuerung des Leistungsflusses angeschlossen ist, einer zweiten Klemme (K2), die mit der zweiten Klemme (B2) der Vorrichtung zur Steuerung des Leistungsflusses angeschlossen ist, einer dritten Klemme (K3), die mit dem dritten Klemme (B3) der Vorrichtung zur Steuerung des Leistungsflusses angeschlossen ist, und dass sie mindestens eine Vorrichtung zur Begrenzung der Stromänderung umfasst, die zwischen einer ihrer drei Klemmen (K1, K2, K3) und der entsprechenden Klemme der Vorrichtung zur Steuerung des Leistungsflusses angeschlossen ist.

6. System nach Anspruch 5, **dadurch gekennzeichnet, dass** es mindestens eine Spannungsbegrenzungsvorrichtung enthält, die zwischen zwei seiner drei Klemmen angeschlossen ist.

7. System nach einem der Ansprüche 1 bis 6, **dadurch gekennzeichnet, dass** die Vorrichtung zur Steuerung des Leistungsflusses **dadurch gekennzeichnet ist, dass** sie Folgendes umfasst:

- Eine erste Spannungsquelle, die zwischen ihrer ersten Klemme (B1) und ihrer dritten Klemme (B3) angeschlossen ist,
- Eine zweite Spannungsquelle, die zwischen ihrer zweiten Klemme (B2) und ihrer dritten Klemme (B3) angeschlossen ist,
- Eine Stromquelle, die abwechselnd mit der ersten Spannungsquelle und der zweiten Spannungsquelle angeschlossen und so gestaltet ist, dass sie eine Energieübertragung zwischen der ersten Spannungsquelle und der zweiten Spannungsquelle bewirkt,
- Die erwähnten Schaltmittel sind so gestaltet, dass sie eine Verbindung der jeweiligen Stromquelle abwechselnd, parallel zur ersten Spannungsquelle oder parallel zur zweiten Stromquelle ermöglichen,
- Die erwähnten Steuerungsmittel (21) sind so gestaltet, dass sie die Schaltmittel so regeln, dass sie die Verbindung der Stromquelle abwechselnd, parallel zur ersten Spannungsquelle oder parallel zur zweiten Stromquelle durchführen und eine Energieübertragung zwischen der ersten Spannungsquelle und der zweiten Spannungsquelle über die Stromquelle regeln.

8. System nach Anspruch 7, **dadurch gekennzeichnet, dass** die erste Spannungsquelle wenigstens einen Kondensator (C1) aufweist.

9. System nach Anspruch 7 oder 8, **dadurch gekennzeichnet, dass** die zweite Spannungsquelle wenigstens einen Kondensator (C2) aufweist.

10. System nach einem der Ansprüche 7 bis 9, **dadurch gekennzeichnet, dass** die Stromquelle wenigstens einen Feldstrom (L) aufweist.

11. System nach Anspruch 10, **dadurch gekennzeichnet, dass** die Schaltmittel sechs Schalter umfassen:

- Ein erster Satz von zwei ersten Schaltern (S1, S2), die zwischen der ersten Klemme (B1) und der dritten Klemme (B3) der Vorrichtung parallel zur ersten Spannungsquelle angeschlossen sind, wobei die beiden Schalter (S1, S2) des ersten Satzes zwischen sich einen ersten mittleren Verbindungspunkt definieren;
- Ein zweiter Satz von zwei Schaltern (S5, S6), die zwischen der zweiten Klemme (B2) und der dritten Klemme (B3) parallel zur zweiten Spannungsquelle angeschlossen sind, wobei die beiden Schalter (S5, S6) des zweiten Satzes zwischen sich einen zweiten mittleren Verbindungspunkt definieren;
- Ein dritter Schalter (S3), der zwischen der zweiten Klemme (B2) und dem ersten Mittelpunkt des ersten Satzes von Schaltern angeschlossen ist;
- Ein vierter Schalter (S4), der zwischen der ersten Klemme (B1) und dem zweiten Mittelpunkt des zweiten Satzes von Schaltern angeschlossen ist.

12. System nach Anspruch 11, **dadurch gekennzeichnet, dass** der Feldstrom (L) zwischen dem ersten Mittelpunkt und dem zweiten Mittelpunkt angeschlossen ist.

13. System nach Anspruch 11 oder 12, **dadurch gekennzeichnet, dass** jeder Schalter entsprechend dem Zeichen der folgenden Parameter ausgewählt wird:

- Strom $I_1$;
- Strom $I_2$;
- Verhältnis $I_1/I_2$;
- Differenz $I_1 - I_2$;

- Differenz Vx=Vi-V$_2$;

- Verhältnis $\dfrac{V1-V2}{I1+I2}$

Wobei:

- I$_1$ dem Strom entspricht, der in der ersten Verbindung fließt;
- I$_2$ dem Strom entspricht, der in der zweiten Verbindung fließt;
- V$_1$ der Spannung an der ersten Spannungsquelle entspricht;
- V$_2$ der Spannung an der zweiten Spannungsquelle entspricht.

14. System nach Anspruch 13, **dadurch gekennzeichnet, dass** jeder Schalter ausgewählt ist aus:

- Einem offenen Stromkreis;
- Einem Kurzschluss;
- Einer Diode;
- Einem nicht brückend gesteuerten Schalter;
- Einem brückend gesteuerten Stromschalter;
- Einem brückend gesteuerten Spannungsumkehrschalter;
- Einem brückend gesteuerten Strom- und Spannungsumkehrschalter;
- Einem einzelnen mechanischen Schalter;
- Einem mechanischer Schalter in Serie mit einer Diode;
- Einem mechanischer Schalter in Serie mit einem gesteuerten Schalter;

15. System nach einem der Ansprüche 1 bis 6, **dadurch gekennzeichnet, dass** die Vorrichtung zur Steuerung des Leistungsflusses eine Spannungsquelle umfasst und dass die Schaltmittel Schalter (T1-T6) umfassen, die in drei Schaltarmen angeordnet sind, die jeweils parallel zur Spannungsquelle angeschlossen sind, wobei jeder Schaltarm zwei Schalter in Serie umfasst, wobei der Mittelpunkt des ersten Schaltarms mit der ersten Klemme (B1) der Vorrichtung angeschlossen ist, der Mittelpunkt des zweiten Schaltarms mit der zweiten Klemme (B2) angeschlossen ist und der Mittelpunkt des dritten Schaltarms mit der dritten Klemme (B3) der Vorrichtung angeschlossen ist.

## Claims

1. System for use in a mesh network, a mesh comprising at least three nodes, each at a determined voltage, the said system having a power flow controller arranged to control the power flows in the mesh and having a first terminal (B1) to be connected to a first mesh link, a second terminal (B2) to be connected to a second mesh link and a third terminal (B3) to be connected to a network link, at least one passive voltage source, means of switching connected to the said voltage source and means of control configured to control the said means of switching to ensure a current distribution in the said two mesh links, the said device having several diodes and the said means of switching comprising several switches chosen from:

- A non-reversible controlled switch;
- A current-reversible controlled switch;
- A voltage-reversible controlled switch;
- A current and voltage-reversible controlled switch;
- A mechanical switch;
- A mechanical switch connected in series with a diode;
- A mechanical switch connected in series with a controlled switch;

The system comprising means of detection of an electrical fault in the device and means of identifying the type of electrical fault detected,

Whereby the said system comprises means of protection of the said power flow controller, the said means of protection comprising:

- A bypass switch placed in parallel with each diode of the power flow controller;
- A bypass switch placed in parallel with each power flow controller switch, unless the switch is a controlled non-reversible switch;
- A voltage limiting device connected to the terminals of each passive voltage source;
- And whereby it comprises the means of control of each bypass and each means of switching of the power flow controller in accordance with a control sequence suitable for the type of electrical fault detected.

2. System according to claim 1, whereby each bypass switch comprises a thyristor, two thyristors connected head to tail or a group of thyristors connected in parallel and/or in series.

3. System according to claim 1 or 2, whereby each voltage limiting device comprises at least one lightning arrester.

4. System according to claims 1 to 3, whereby it comprises at least one voltage limiting device connected between at least two terminals of the power flow controller.

5. System according to one of claims 1 to 4, whereby it comprises three terminals (K1, K2, K3), a first terminal (K1) connected to the said first terminal (B1) of the power flow controller, a second terminal (K2) connected to the said second terminal (B2) of the power flow controller, a third terminal (K3) connected to the said third terminal (B3) of the power flow controller and in comprising at least one current variation limiting device connected between one of the three terminals (K1, K2, K3) and the corresponding terminal of the power flow controller.

6. System according to claim 5, whereby it comprises at least one voltage limiting device connected between two of its three terminals.

7. System according to claims 1 to 6, whereby the said power flow controller comprises:

   - A first voltage source connected between its first terminal (B1) and its third terminal (B3);
   - A second voltage source connected between its second terminal (B2) and its third terminal (B3);
   - A current source connected alternately to the first voltage source and the second voltage source and configured to provide a transfer of energy between the first voltage source and the second voltage source.
   - The said means of switching being configured to enable connection of the said current source alternately, in parallel with the
   - first voltage source or in parallel with the second current source,
   - The said means of control (21) being configured to control the said means of switching so as to make the said connection of the said alternating source of current, in parallel with the first voltage source or in parallel with the second current source and to control a transfer of energy between the first voltage source and the second voltage source via the said current source.

8. System according to claim 7, whereby the first voltage source comprises at least one capacitor (C1).

9. System according to claim 7 or 8, whereby the first voltage source comprises at least one capacitor (C2).

10. System according to one of claims 7 to 9, whereby the current source comprises at least one inductor (L).

11. System according to claim 10 whereby the means of switching comprise six switches:

    - A first set of two first switches (Si, $S_2$) connected between the first terminal (B1) and the third terminal (B3) of the device, in parallel with the first voltage source, the two switches (Si, $S_2$) of the first set defining between them a first centre connection point;
    - A second set of two second switches ($S_5$, $S_6$) connected between the second terminal (B2) and the third terminal (B3) of the device, in parallel with the second voltage source, the two switches ($S_5$, $S_6$) of the second set defining between them a second centre connection point;
    - A third switch ($S_3$) connected between the second terminal (B2) and the first centre point of the first set of switches;
    - A fourth switch (S4) connected between the first terminal (B1) and the second centre point of the second set of switches.

12. System according to claim 11, whereby the inductor (L) is connected between the first centre point and the second centre point.

13. System according to claim 11 or 12, whereby each switch is chosen according to the sign of the following parameters:

    - The current $I_1$;
    - The current $I_2$;
    - The ratio I1/I2;
    - The difference I1-$I_2$;
    - The difference Vx=V1-$V_2$;
    - The ratio $\dfrac{V_1-V_2}{I_1+I_2}$ ;

   Where:

    - $I_1$ is the current flowing in the first link;
    - $I_2$ is the current flowing in the second link;
    - V1 is the voltage at the terminals of the first voltage source;
    - V2 is the voltage at the terminals of the second voltage source.

14. System according to claim 13, whereby each switch is chosen from:

    - An open circuit;
    - A short-circuit;
    - A diode;
    - A non-reversible controlled switch;
    - A current-reversible controlled switch;
    - A voltage-reversible controlled switch;
    - A current and voltage-reversible controlled switch;
    - A mechanical switch alone;
    - A mechanical switch connected in series with a diode;
    - A mechanical switch connected in series with a controlled switch;

15. System according to claims 1 to 6, whereby the said power flow controller comprises a voltage source and whereby the means of switching comprises switches (T1-T6) arranged in three switching arms each one connected in parallel with the voltage source, each switching arm comprising two switches in series, the centre point of the first switching arm being connected to the first terminal (B1) of the device, the centre point of the second switching arm connected to the second terminal (B2) and the centre point of the third switching arm being connected to the third terminal (B3) of the device.

**Fig. 1**

**Fig. 2**

**Fig. 3**

*Fig. 4*

*Fig. 5*

*Fig. 6*

**Fig. 7A**

**Fig. 7B**

*Fig. 8A*

*Fig. 8B*

**Fig. 9A**

**Fig. 9B**

**Fig. 10A**

**Fig. 10B**

**Fig. 11**

**Fig. 11.1_A**

**Fig. 11.1_B**

**Fig. 11.2_A**

**Fig. 11.2_B**

Fig. 11.3_A

Fig. 11.3_B

**Fig. 11.4_A**

**Fig. 11.4_B**

**Fig. 12A**

E1 — Mesure/Détection

E2 — Identification/Localisation

E3 — Commande

**Fig. 12B**

E1 — Mesure/Détection

E2 — Identification/Localisation

E3 —

Fermeture Interrupteurs de contournement — E30

Ouverture Interrupteurs du dispositif — E31

Ouverture Interrupteurs du dispositif — E300

Fermeture Interrupteurs de contournement — E310

— E3

**Fig. 12C**

E2 —

$V1\_m \quad V2\_m \quad DV\_m$

N — $V1\_m >= V1lim$ — Y

$DV\_m >= DVmax$ — N / Y

X1 ou X3

X2

$V2\_m <= Vlim$

Y — X1

N — X3

*Fig. 13A*

*Fig. 13B*

**Fig. 14A**

**Fig. 14B**

**Fig. 15A**

**Fig. 15B**

**Fig. 16A**

**Fig. 16B**

*Fig. 17A*

*Fig. 17B*

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2010115452 A1
- WO 2013013858 A1
- EP 3007301 A1
- EP 3007300 A1
- WO 2013178807 A1
- US 2015180231 A1
- EP 3032677 A1
- EP 2975723 A1
- WO 2016008927 A1

**Littérature non-brevet citée dans la description**

- **S. BALASUBRAMANIAM.** Experimental Validation of Dual H-Bridge Current Flow Controllers for Meshed HVDC Grids. *IEEE Transactions on Power Delivery,* 18 Septembre 2017, (99
- **J. SAU-BASSOLS.** Series interline DC/DC Current Flow Controller for meshed HVDC grids. *IEEE Transactions on Power Delivery,* 31 Juillet 2017, (99